(19) Europäisches Patentamt / European Patent Office / Office européen des brevets

(11) EP 2 221 884 A1

(12) EUROPEAN PATENT APPLICATION
published in accordance with Art. 153(4) EPC

(43) Date of publication:
25.08.2010 Bulletin 2010/34

(51) Int Cl.:
*H01L 33/00* (2010.01)

(21) Application number: 08844428.6

(22) Date of filing: 29.10.2008

(86) International application number:
PCT/JP2008/069682

(87) International publication number:
WO 2009/057655 (07.05.2009 Gazette 2009/19)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 29.10.2007 JP 2007280229

(71) Applicant: Mitsubishi Chemical Corporation
Minato-ku
Tokyo 108-0014 (JP)
(72) Inventors:
• HORIE, Hideyoshi
Ushiku-shi
Ibaraki 300-1295 (JP)
• HIRASAWA, Hirohiko
Joetsu-shi
Niigata 942-8611 (JP)

(74) Representative: Luderschmidt, Schüler & Partner
Patentanwälte
John-F.-Kennedy-Strasse 4
65189 Wiesbaden (DE)

(54) **SEMICONDUCTOR LIGHT EMITTING ELEMENT AND METHOD FOR MANUFACTURING THE SAME**

(57) A light-emitting element (10) is provided with a thin-film crystal layer which includes a buffer layer (22), a first-conductivity-type semiconductor layer, an active structure (25) and a second-conductivity-type semiconductor layer. In the thin-film crystal layer, at least a part of the second-conductivity-type semiconductor layer is covered with an insulating film. The insulating film has a crystal quality improving layer (30) for recovering crystallinity of the thin-film crystal layer.

[FIG. 1]

EP 2 221 884 A1

## Description

Technical Field

The present invention relates to a semiconductor light-emitting element, particularly to a semiconductor light-emitting element in which a predetermined thin-film crystal layer including a buffer layer is laminated and a manufacturing process therefor.

More particularly, the present invention relates to a semiconductor light-emitting element, particularly a flip-chip type semiconductor light-emitting element in which a predetermined thin-film crystal layer including a buffer layer is laminated and which has electrodes for current injection in the same side of the buffer layer, and a manufacturing process therefor.

Background Art

Recently, intense attempts have been made for developing a semiconductor light-emitting element employing a compound semiconductor containing a gallium nitride such as GaN, AlGaN and InGaN (hereinafter, sometimes simply referred to as "light-emitting element").

Furthermore, a luminescence source combining a light-emitting element emitting blue light and a yellow phosphor excited by the blue light has been practically used as a light source for a lighting device emitting white light. This luminescence source does, however, not have very high color rendering properties because white light is provided by mixing blue light emitted from the light-emitting element with yellow light emitted from the yellow phosphor.

Thus, for providing a white illuminating device with higher color rendering properties, there has been investigated a luminescence source as a combination of three-color phosphors, that is, a blue, a green and a red phosphors with a light-emitting element. This luminescence source employs, for example, a light-emitting element emitting near-ultraviolet light. The blue, green and red phosphors are excited by near-ultraviolet light emitted from the light-emitting element, to conduct wavelength conversion of near-ultraviolet light into blue, green and red lights, respectively. Then, white light with higher color rendering properties can be provided by mixing three color lights obtained by the wavelength conversion.

A luminous efficiency is, however, generally lower in a light-emitting element emitting near-ultraviolet light than a light-emitting element emitting blue light. Thus, it is needed that an output and an luminous efficiency are further improved in a light-emitting element emitting near-ultraviolet light.

A laminate structure of a semiconductor layer in a light-emitting element is generally formed by film crystal growth. This film crystal state significantly influences the light-emitting properties of a light-emitting element at the fine level. For example, a semiconductor layer formed by film crystal growth, particularly the interface or the outermost surface of its laminate structure may be damaged during the process of film crystal growth and further the subsequent processes, leading to deterioration in a crystalline state. Deterioration in a crystalline state adversely affects reliability of the light-emitting element, and therefore, there is needed to provide a light-emitting element with less deterioration in a crystalline state.

As described above, reduction in such deterioration in a crystal state damage is crucially important for providing a light-emitting element meeting the recent requirement for a higher output and a higher luminous efficiency.

A flip-chip mount structure is known as a structure effective for increasing an output and a luminous efficiency in a light-emitting element. In this structure, a predetermined semiconductor layer is deposited on a substrate, an n-side electrode and a p-side electrode for current injection is formed in the opposite side of the substrate and the substrate side is a main light extraction direction. Thus, light emitted from the light-emitting element is not blocked and the electrode can be used as a light reflecting surface, resulting in an improved light extraction efficiency.

Such a flip-chip mount structure often has a configuration where the laminate structure formed on the substrate is covered with an insulating film for preventing unintended short circuit between electrodes when a light-emitting element is mounted on a submount (substrate for interconnection or heat dissipation).

There is a conventionally known light-emitting element in which an insulating film has a light-reflection function for further improving a light extraction efficiency.

Patent References 1 to 3 have disclosed a light-emitting element with an insulating film having a light-reflection function by constituting the insulating film by one or multiple dielectric multilayer films consisting of an $SiO_2$ and $TiO_2$ films. The insulating film having a light-reflection function is formed covering the lateral side of the light-emitting element and the opposite side of the substrate such that at least part of the electrode is exposed. Thus, a light generated within the light-emitting element and travelling opposite to the lateral side of the light-emitting element and the substrate is reflected to the substrate side, so that a light extraction efficiency from the substrate side can be further improved.

Patent Reference 1: Japanese Patent No. 3423328.
Patent Reference 2: Japanese published unexamined application No. 2000-164938.
Patent Reference 3: Japanese published unexamined application No. 2002-344015.

Disclosure of the Invention

Subject to be solved by the Invention

However, a conventional light-emitting element, particularly a light-emitting element based on a flip-chip type mount, has a configuration in which most of the light generated within the element is extracted from the substrate side (or the opposite side to the reflection electrode in, for example, an element without a substrate), so that the light distribution properties of the extracted light is significantly biased, resulting in increase in a spatial radiant flux density above the light-emitting element. Furthermore, for example, for a light-emitting element emitting near-ultraviolet light, near-ultraviolet light has higher energy than visible light such as blue light, so that a spatial energy density of the extracted light above the light-emitting element is further increased. Excessive increase in a spatial energy density due to bias of the light distribution properties for the light emitted from the light-emitting element causes considerable deterioration of a phosphor in a luminescence source as a combination of the light-emitting element with the phosphor.

As described above, a laminate structure of a semiconductor layer in a light-emitting element is generally formed by film crystal growth. A semiconductor layer formed by film crystal growth, particularly its surface is damaged during the process of film crystal growth and further the subsequent processes, leading to deterioration in a crystalline state. Deterioration in a crystalline state adversely affects reliability of the light-emitting element, and therefore, it is also important for a light-emitting element that deterioration in a crystalline state is reduced.

Thus, an objective of the present invention is to improve the quality of a light-emitting element itself for meeting the requirement for further increase in an output and a luminous efficiency. In addition, another objective of the present invention is to provide a light-emitting element having light distribution properties sufficiently proper for preventing deterioration of a phosphor without a radiation flux and a luminous efficiency in the light-emitting element being reduced when the light-emitting element and the phosphor are combined and consequently reducing a spatial radiant flux density or energy density above the light-emitting element (or the opposite side to the reflection electrode in, for example, an element without a substrate) and a manufacturing process therefor.

MEANS to be solve the Subject

To achieve the above objectives, the present invention relates to the following items.

[1] A semiconductor light-emitting element comprising a thin-film crystal layer in which a buffer layer, a first-conductivity-type semiconductor layer including a first-conductivity-type cladding layer, an active layer structure and a second-conductivity-type semiconductor layer including a second-conductivity-type cladding layer are laminated in sequence, wherein

said thin-film crystal layer is covered with an insulating film at least a part of said second-conductivity-type semiconductor layer, and

said insulating film comprises a crystal quality improving layer for improving crystallinity of said thin-film crystal layer.

[2] The semiconductor light-emitting element described in [1], wherein said insulating film further comprises at least one antireflection layer which is formed covering at least a part of said crystal quality improving layer and reduces reflection of a light entering from the side of said thin-film crystal layer.

[3] The semiconductor light-emitting element described in [2], wherein when a light reflectance of said insulating film when a light generated in said thin-film crystal layer vertically enters said insulating film is R %, said antireflection layer is adjusted such that the relation:

$$0.001\,(\%) < R < 3\,(\%)$$

is satisfied.

[4] The semiconductor light-emitting element described in [3], wherein said antireflection layer consists of a single layer.

[5] The semiconductor light-emitting element described in any of [2] to [4], wherein said antireflection layer is made of a material selected from the group consisting of $AlO_x$, $SiO_x$, $TiO_x$, $MgF_2$, $SiN_x$ and $SiO_xN_y$.

[6] The semiconductor light-emitting element described in any of [1] to [5], wherein the whole surface of said second-conductivity-type-side electrode facing said second-conductivity-type semiconductor layer is in contact with said second-conductivity-type semiconductor layer and said insulating film also covers a part of said second-conductivity-type-side electrode.

[7] The semiconductor light-emitting element described in any of [1] to [6], wherein said first-conductivity-type-side electrode is in contact with said first-conductivity-type semiconductor layer only in a part of the surface facing said first-conductivity-type semiconductor layer, and a part of said insulating film intervenes between said first-conductivity-type semiconductor layer and said first-conductivity-type-side electrode.

[8] The semiconductor light-emitting element described in any of [1] to [7], wherein said insulating film is in contact with at least a part of the sidewall of said thin-film crystal layer.

[9] The semiconductor light-emitting element described in any of [1] to [8], wherein said first-conductivity-type semiconductor layer, said active layer structure and said second-conductivity-type semiconductor layer are nitride semiconductors.

[10] The semiconductor light-emitting element described in [9], wherein each of said nitride semiconductors comprises at least one element selected from the group consisting of In, Ga, Al and B.

[11] The semiconductor light-emitting element described in any of [1] to [10], wherein a center wavelength $\lambda$ (nm) of a light emitted from the inside of said active layer structure satisfies the following formula.

$$300 \; (\text{nm}) \le \lambda \le 430 \; (\text{nm})$$

[12] The semiconductor light-emitting element described in any of [1] to [11], wherein the first-conductivity-type is n-type and the second-conductivity-type is p-type.

[13] The semiconductor light-emitting element described in any of [1] to [12], wherein the surface of said second-conductivity-type semiconductor layer contains Mg and H.

[14] The semiconductor light-emitting element described in any of [1] to [13], wherein said crystal quality improving layer contains N and H.

[15] The semiconductor light-emitting element described in [14], wherein a hydrogen-atom concentration in said crystal quality improving layer is $1 \times 10^{21}$ atoms/cm$^3$ or more and $1 \times 10^{22}$ atoms/cm$^3$ or less.

[16] The semiconductor light-emitting element described in any of [1] to [15], wherein said crystal quality improving layer contains one or more of a nitride and an oxynitride.

[17] The semiconductor light-emitting element described in [16], wherein said nitride and said oxynitride contain one or more elements selected from the group consisting of B, Al, Si, Ti, V, Cr, Mo, Hf, Ta and W.

[18] The semiconductor light-emitting element described in any of [1] to [17], wherein the semiconductor light-emitting element is a flip-chip type in which both first-conductivity-type-side electrode and second-conductivity-type-side electrode for injecting current into said first-conductivity-type semiconductor layer and said second-conductivity-type semiconductor layer, respectively, are disposed in the same side as said first-conductivity-type semiconductor layer to said buffer layer.

[19] A process for manufacturing a semiconductor light-emitting element, sequentially comprising:

a step of crystal growing where on a substrate is formed a thin-film crystal layer comprising a buffer layer, a first-conductivity-type semiconductor layer including a first-conductivity-type cladding layer, an active layer structure and a second-conductivity-type semiconductor layer including a second-conductivity-type cladding layer;

a step of forming a second-conductivity-type-side electrode where a second-conductivity-type-side electrode is formed on a predetermined second current injection area on said second-conductivity-type semiconductor layer;

a first etching step where a part of said first-conductivity-type-side semiconductor layer is exposed;

a step of forming an insulating film where the insulating film comprising a crystal quality improving layer for improving crystallinity of said thin-film crystal layer is formed such that the insulating film covers at least a part of said second-conductivity-type semiconductor layer and a part of said first-conductivity-type semiconductor layer;

a step of forming a first current injection area where the first current injection area is formed by removing at least a part on said first-conductivity-type semiconductor layer of said insulating film; and

a step of forming a first-conductivity-type-side electrode where the first-conductivity-type-side electrode is formed on said first current injection area.

[20] The process for manufacturing a semiconductor light-emitting element described in [19], wherein said step of forming the insulating film comprises forming an antireflection layer reducing reflection of a light entering on said crystal quality improving layer from said thin-film crystal layer side.

[21] The process for manufacturing a semiconductor light-emitting element described in [20], wherein when a reflectance when a light from the side of said thin-film crystal layer vertically enters said crystal quality improving layer and said antireflection layer is R %, said step of forming the insulating film comprises forming said antireflection layer such that the relation

$$0.001 \, (\%) < R < 3 \, (\%)$$

is satisfied.
[22] The process for manufacturing a semiconductor light-emitting element described in [20] or [21], wherein said step of forming the insulating film comprises continuously forming said crystal quality improving layer and said antireflection layer in the same deposition apparatus.

[23] The process for manufacturing a semiconductor light-emitting element described in any of [19] to [22], wherein said crystal quality improving layer comprises one or more of a nitride and an oxynitride.

[24] The process for manufacturing a semiconductor light-emitting element described in [23], wherein said nitride and said oxynitride contain one or more elements selected from the group consisting of B, Al, Si, Ti, V, Cr, Mo, Hf, Ta and W.

[25] The process for manufacturing a semiconductor light-emitting element described in any of [19] to [24], wherein said step of forming the insulating film comprises forming said crystal quality improving layer using a gas species containing at least ammonia as a nitrogen source.

[26] The process for manufacturing a semiconductor light-emitting element described in any of [19] to [25], wherein said step of forming the insulating film comprises forming said crystal quality improving layer using a gas species containing at least $N_2O$ as an oxygen source.

[27] The process for manufacturing a semiconductor light-emitting element described in any of [19] to [26], wherein said step of forming the insulating film comprises forming said crystal quality improving layer by plasma CVD.

[28] The process for manufacturing a semiconductor light-emitting element described in any of [19] to [27], wherein said step of forming the insulating film comprises forming said crystal quality improving layer such that a hydrogen-atom concentration is $1 \times 10^{21}$ atoms/cm$^3$ or more and $1 \times 10^{22}$ atoms/cm$^3$ or less.

Effect of the Invention

According to the present invention, there can be provided a semiconductor light-emitting element in which crystallinity in a thin-film crystal layer is improved and a crystalline state is less deteriorated and which can meet the requirement for a higher output and a higher luminous efficiency, by forming an insulating film having a crystal quality improving layer as described above. Additionally, by forming an insulating film with an extremely low reflectance as a multilayer film containing an antireflection layer, a light emitted from the thin-film crystal layer of the semiconductor light-emitting element can be extracted through the insulating film. Thus, compared with a conventional semiconductor light-emitting element having an insulating film mainly exerting reflection function, a spatial radiant flux density above the light-emitting element is reduced, even when the total radiation flux is equal. That is, it can be expected that a flip-chip type semiconductor light-emitting element having an insulating film with an extremely low reflectance allows for light emission from, not only the top of the element, all directions of the element such as a sidewall and an electrode side.

Therefore, the light-emitting element of the present invention allows for considerable reduction in a spatial radiation flux above the light-emitting element and for light emission in various directions such as the lateral side and the electrode side (lower side) of the light-emitting element, in contrast to a semiconductor light-emitting element having an insulating film having reflection function in which light emission is mainly from the substrate side in the presence of a substrate for growth of a thin-film crystal layer or from the opposite side to the reflection electrode in an element without a substrate. Thus, quality of a semiconductor light-emitting element unit can be improved to meet the requirement for a higher output and a higher luminous efficiency, and when a luminescence source is constructed using this semiconductor light-emitting element as a phosphor-exciting light source, deterioration of a phosphor can be prevented without reduction in an output or a luminous efficiency as a whole.

Above effect is prominent particularly when a luminescence source is constructed by combining a light-emitting element with a high radiant energy emitting ultraviolet and near-ultraviolet light (or with a shorter wavelength in comparison with, for example, blue or green light) with a phosphor.

Brief Description of the Drawings

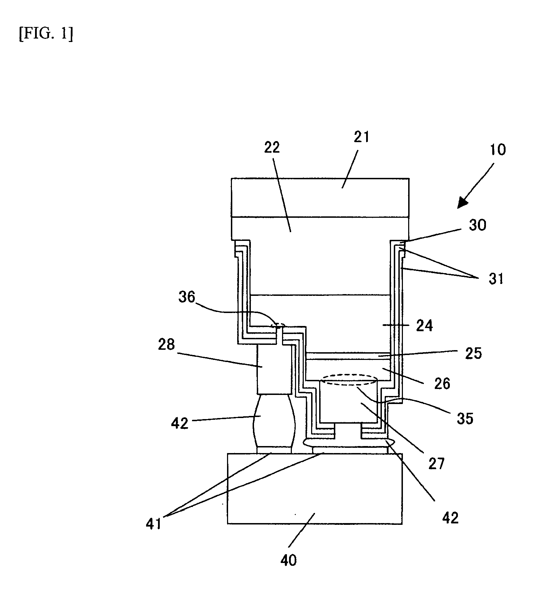

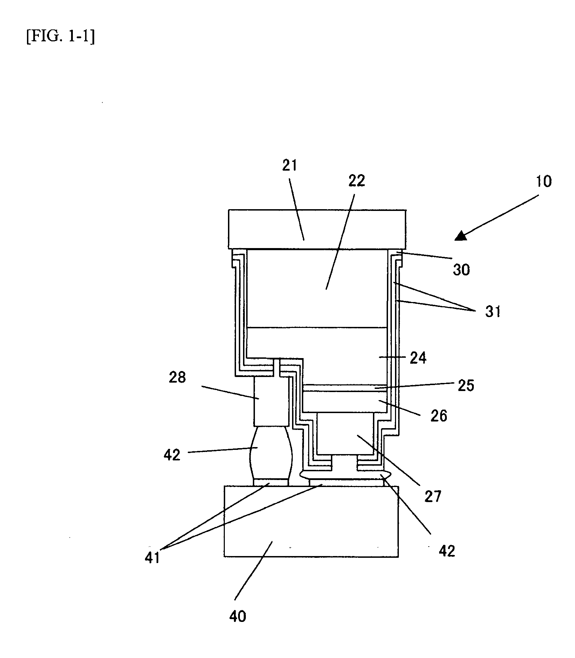

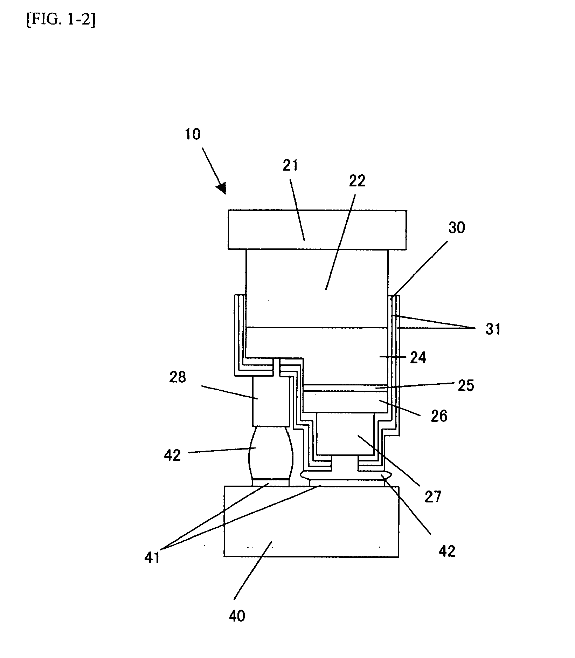

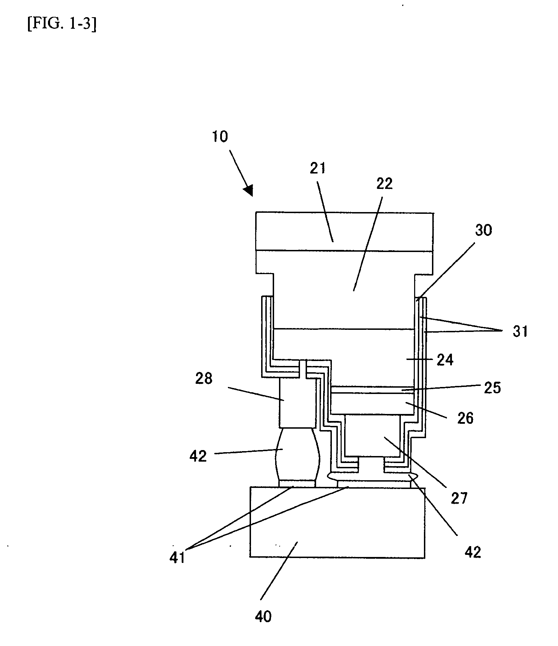

    FIG. 1 is a cross-sectional view of a light-emitting element according to one embodiment of the present invention.
    FIG. 1-1 is a cross-sectional view of another aspect of a light-emitting element of the present invention.
    FIG. 1-2 is a cross-sectional view of another aspect of a light-emitting element of the present invention.
    FIG. 1-3 is a cross-sectional view of another aspect of a light-emitting element of the present invention.
    FIG. 2 is a cross-sectional view illustrating a part of the light-emitting element in FIG. 1 in detail.

    FIG. 3 is a cross-sectional view illustrating an example of a manufacturing process for the light-emitting element shown in FIG. 1.
    FIG. 4 is a cross-sectional view illustrating an example of a manufacturing process for the light-emitting element shown in FIG. 1.
    FIG. 5 is a cross-sectional view illustrating an example of a manufacturing process for the light-emitting element shown in FIG. 1.
    FIG. 6 is a cross-sectional view illustrating an example of a manufacturing process for the light-emitting element shown in FIG. 1.
    FIG. 7 is a cross-sectional view illustrating an example of a manufacturing process for the light-emitting element shown in FIG. 1.
    FIG. 8 is a cross-sectional view illustrating an example of a manufacturing process for the light-emitting element shown in FIG. 1.
    FIG. 9 is a graph showing relationship between a thickness of $SiO_x$ and a reflectance when by plasma CVD, $SiN_x$ is deposited on a thin-film crystal layer to 30 nm and then $SiO_x$ is deposited.
    FIG. 10 is a cross-sectional view of the light-emitting element manufactured in Example 1.
    FIG. 11 is a graph illustrating relationship between a reflectance of the insulating film and a thickness of $SiO_x$ in Example 1.
    FIG. 12 is a graph illustrating relationship between a reflectance of the insulating film and a thickness of $SiO_x$ in Example 2.
    FIG. 13 is a graph illustrating relationship between a reflectance of the insulating film and a thickness of $SiO_x$ in Example 3.
    FIG. 14 is a graph illustrating relationship between a reflectance of the insulating film and a thickness of $MgF_2$ in Example 4.
    FIG. 15 is a graph illustrating relationship between a reflectance of the insulating film and a thickness of $SiO_x$ in Example 5.
    FIG. 16 is a graph illustrating relationship between a reflectance of the insulating film and a thickness of $SiO_x$ in Example 6.
    FIG. 17 is a graph illustrating relationship between an PL intensity of a thin-film crystal layer and a wavelength in each step in Example 8.
    FIG. 18 is a graph illustrating relationship between an PL intensity of a thin-film crystal layer and a wavelength in each step in Example 11.
    FIG. 19 is a graph illustrating relationship between an PL intensity of a thin-film crystal layer and a wavelength in each step in Example 12.
    FIG. 20 is a graph illustrating relationship between an PL intensity of a thin-film crystal layer and a wavelength in each step in Example 13.
    FIG. 21 is a cross-sectional view of a light-emitting element according to another embodiment of the present invention.
    FIG. 22 is a cross-sectional view of a light-emitting element according to another aspect of the present invention.

Description of Reference Numerals

| | |
|---|---|
| 10 | light-emitting element |
| 21 | substrate |
| 22 | buffer layer |
| 24 | first-conductivity-type cladding layer |
| 25 | active layer structure |
| 26 | second-conductivity-type cladding layer |
| 27 | second-conductivity-type-side electrode |
| 28 | first-conductivity-type-side electrode |
| 40 | submount |

Best Mode for Carrying the Invention

The present invention will be described in detail below, but the present invention is not limited to the embodiments described below and can be modified in any of various styles within the scope of this invention.

In the present application, the term, "stacked" or "overlap" may refer to, in addition to the state that materials are directly in contact with each other, the state that even when being not in contact with each other, one material spatially overlaps the other material when one is projected to the other, as long as it does not depart from the gist of the invention. The term, "over or on··· (under ···)" may also refer to, in addition to the state that materials are directly in contact with each other and one is placed on (under) the other, the state that even when being not in contact with each other, one is placed over (below) the other, as long as it does not depart from the gist of the invention. Furthermore, the term, "rafter ··· (before or prior to ···)" may be applied to not only the case where one event occurs immediately after (before) another event, but also the case where a third event intervenes between one event and another subsequent (preceding) event. The term, "contact" may refer to, in addition to the case where "materials are directly in contact with each other", the case where "materials are indirectly in contact with each other via a third member without being not directly in contact with each other" or where "a part where materials are directly in contact with each other and a part where they are indirectly in contact with each other via a third member are mixed", as long as it fits the gist of the present invention.

Furthermore, in the present invention, the term, "thin-film crystal growth" may refer to formation of a thin-film layer, an amorphous layer, a microcrystal, a polycrystal, a single crystal or a stacked structure of these in a crystal growth apparatus by, for example, MOCVD (Metal Organic Chemical Vapor Deposition), MBE(Molecular Beam Epitaxy), plasma assisted MBE, PLD (Pulsed Laser Deposition), PED(Pulsed Electron Deposition), VPE(Vapor Phase Epitaxy) or LPE(Liquid Phase Epitaxy), including, for example, a subsequent carrier activating process of a thin-film layer such as heating and plasma treatment.

A semiconductor light-emitting element (hereinafter, simply referred to as "light-emitting element") according to one embodiment of the present invention has a substrate 21 and a compound semiconductor thin-film crystal layer (hereinafter, sometimes simply referred to as "thin-film crystal layer") laminated on one side of the substrate 21, as shown in FIG. 1. The compound semiconductor thin-film crystal layer has a configuration where a buffer layer 22, a first-conductivity-type semiconductor layer containing a first-conductivity-type cladding layer 24, active layer structure 25 and a second-conductivity-type semiconductor layer containing a second-conductivity-type cladding layer 26 are sequentially laminated from the side of the substrate 21.

On a part of the second-conductivity-type cladding layer 26, the second-conductivity-type-side electrode 27 for current injection is disposed and the part where the second-conductivity-type cladding layer 26 and the second-conductivity-type-side electrode 27 are in contact with each other is a second current injection region 35 for injecting current into the second-conductivity-type semiconductor layer. In this configuration, a part of the compound semiconductor thin-film crystal layer is removed in its thickness direction from the second-conductivity-type cladding layer 26 side to the intermediate portion of the first-conductivity-type cladding layer 24, and a first-conductivity-type-side electrode 28 for current injection is disposed in contact with the first-conductivity-type cladding layer 24 exposed in the removed part. The part where the first-conductivity-type cladding layer 24 and the first-conductivity-type side electrode 28 are in contact with each other is a first current injection region 36 for injecting current into the first-conductivity-type semiconductor layer.

By disposing the second-conductivity-type-side electrode 27 and first-conductivity-type-side electrode 28 as described above, these are disposed in the same side as the first-conductivity-type semiconductor layer to the buffer layer 22, and the light-emitting element 10 is constructed as a flip-chip type light-emitting element 10.

The second-conductivity-type-side electrode 27 and the first-conductivity-type-side electrode 28 are connected to a metal layer 41 on a submount 40 via a metal solder 42, respectively.

The first-conductivity-type-side electrode 28 and the second-conductivity-type-side electrode 27 are not spatially overlapped. This means that as shown in FIG. 1, when the first-conductivity-type-side electrode 28 and the second-conductivity-type-side electrode 27 are projected to the substrate surface, their shadows are not overlapped.

In the compound semiconductor thin-film crystal layer, at least the part except the area contacting with the second-conductivity-type-side electrode 27 in the second-conductivity-type semiconductor layer is covered with an insulating film. In the example shown in FIG. 1, an insulating film covers a part of the buffer layer 22, a part of the first-conductivity-type semiconductor layer except the first current injection area 36, the active layer structure 25 and a part of the second-conductivity-type semiconductor layer except the second current injection area 35. That is, the insulating film covers at least part of the sidewall of the compound semiconductor thin-film crystal layer having the buffer layer 22, the first-conductivity-type semiconductor layer, the active layer structure 25 and the second-conductivity-type semiconductor layer.

The insulating film also prevents unintentional short circuit due to, for example, flowing of a solder or conductive past material for mounting into "the space between the second-conductivity-type-side electrode and the first-conductivity-type-side electrode" or "the sidewall of a thin-film crystal layer such as an active layer structure" when a light-emitting element is flip-chip mounted.

The insulating film has a crystal quality improving layer 30 for improving crystallinity of a thin-film crystal layer and is preferably constituted by a multilayer film further having at least one antireflection layer 31 formed such that it covers at least part of this crystal quality improving layer 30. In the insulating film, the first layer is the crystal quality improving layer 30, even when the insulating film has the crystal quality improving layer 30 and the antireflection layer 31 as described above. Therefore, the phrase "covered with an insulating film" as used herein, means that the part covered with an insulating film is in contact with the crystal quality improving layer 30.

Although the insulating film may have a part covering at least the second-conductivity-type semiconductor layer as described above, this embodiment further has a configuration where the whole surface of the second-conductivity-type-side electrode 27 facing the second-conductivity-type semiconductor layer is in contact with the second-conductivity-type semiconductor layer and the insulating film also covers a part of the second-conductivity-type-side electrode 27 in contact with the second-conductivity-type semiconductor layer as described above. Such a structure can be obtained by forming the second-conductivity-type-side electrode 27 on the second-conductivity-type cladding layer 26 and then forming the insulating film.

Furthermore, in this embodiment, the first-conductivity-type-side electrode 28 is in contact with the first-conductivity-type semiconductor layer only in a part of the surface facing the first-conductivity-type semiconductor layer, and a part of the insulating film intervenes between the first-conductivity-type semiconductor layer and the first-conductivity-type-side electrode 28. Such a structure can be obtained by forming the insulating film on the first-conductivity-type cladding layer 24 and then forming the first-conductivity-type-side electrode.

Such positional relationship between the insulating film and each electrode allows for producing the light-emitting element 10 by a process with less process damage. In this embodiment, the insulating film is positioned, comprehensively taking process damage and heat dissipation properties and insulation properties during flip-chip mount into account as described above.

As detailed later, the light-emitting element 10 can be produced as a separate light-emitting element 10 by forming a plurality of light-emitting elements 10 on the same substrate 21 and cutting the substrate 21 at the boundary with the adjacent light-emitting element 10. In the light of such a manufacturing process, the light-emitting element of the present invention can take configurations different in two respects, that is, (A) a step shape of the edge in the light-emitting element and (B) a shape of the insulating film in light-emitting element edge, and can be classified into four types shown in FIGs. 1, 1-1, 1-2 and 1-3, depending on a combination.

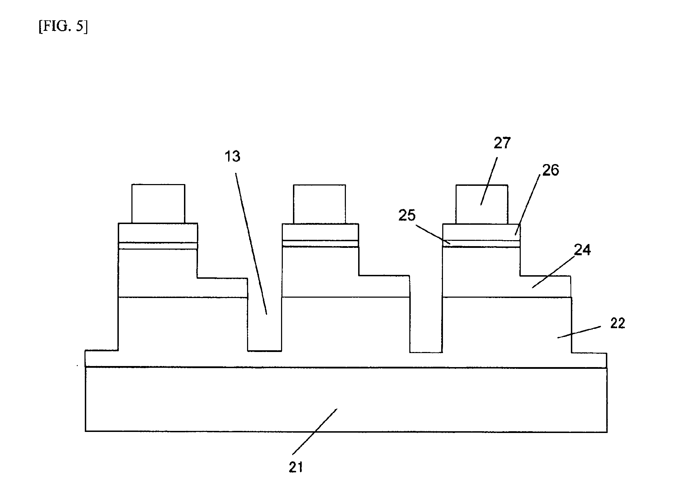

(A) In terms of the step shape of the edge in the light-emitting element, there are generally two options, depending on an etching depth when an inter-device separating trench (the symbol 13 in FIG. 5 described later) is formed in the boundary with an adjacent light-emitting element 10 in the step of forming a plurality of light-emitting elements 10 on the same substrate 21 in the manufacturing process, i.e. (A-i) the depth to the intermediate portion of the buffer layer 22 and (A-ii) the depth to the substrate 21 (or deeper).

Depending on the depth (A-i) to (A-ii) in the inter-device separating trench, in (A-i), a part of the buffer layer 22 forms a sidewall receding from the end face of the light-emitting element 10 which is also the end face of the substrate (hereinafter, sometimes referred to as "element end face") in combination with the first-conductivity-type semiconductor layer, the active layer structure 25 and the second-conductivity-type semiconductor layer and thus there is a step in the sidewall of the buffer layer 22. Here, FIGs. 1 and 1-3 correspond to (A-i). In (A-ii), the whole sidewall of the buffer layer 22 recedes from the element end face and there is a step in the end face of the substrate 21. Furthermore, when in (A-ii) the inter-device separating trench is formed such that the substrate 21 is further dug, a part of the end face of the substrate 21 also forms a sidewall receding from the element end face. The insulating film formed in the sidewall receding from the element end face is not detached during element separation and can efficiently produce its effects. Thus, forming the inter-device separating trench such that the substrate 21 is further dug leads to increase in an area for forming an insulating film in the sidewall of the light-emitting element 10, which is preferable for more effectively producing the effect of the insulating film constituted according the present invention (particularly, the effect of increasing the light amount extracted from the sidewall as described later). FIGs. 1-1 and 1-2 correspond to (A-ii).

(B) In terms of the shape of the insulating film in the edge of the light-emitting element, there are options, in the manufacturing process, removing only the insulating layer in the region including the middle part over the bottom of the separation trench while leaving the insulating layer formed in the sidewall of the separation trench of the light-emitting element and removing a part of the insulating layer on the sidewall within the separation trench, in addition to the whole insulating layer formed in the bottom of the separation trench. In a light-emitting element thus manufactured, there are provided two aspects, that is, (B-i) an aspect where the insulating film is in contact with the bottom of the separation trench and (ii) an aspect where the insulating film is separate from the bottom of the separation trench. FIGs. 1 and 1-1 correspond to (B-i). FIGs. 1-2 and 1-3 correspond to (B-ii).

A shape near the edge of the light-emitting element 10 will be separately described for the aspects (B-i) and (B-ii).

First, there will be described the aspect (B-i) where an insulating film is in contact with the bottom of the separating trench. A typical example of the aspect (B-i) is the shape shown in FIG. 1. The example shown in FIG. 1 is a light-emitting element 10 in which an inter-device separating trench is formed to the middle of the buffer layer 22. Elements are mutually separated within the inter-device separating trench. As a result, in the example shown in FIG. 1, a part of the sidewall surface of the buffer layer 22 coincide with the element end face and from the middle of the buffer layer 22, the sidewall surface gets back from the element end face to give a sidewall surface receding from the element end face together with the sidewall surface of the second-conductivity-type semiconductor layer. Thus, in the buffer layer 22, there is a stepped face between the surface coincident with the element end face and the receding sidewall surface.

Before dividing elements, the insulating film (a laminated film consisting of the crystal quality improving layer 30 and the antireflection layer 31) does not cover the whole bottom of the inter-device separating trench and is not formed in the middle of the bottom of the inter-device separating trench. This part without an insulating film becomes a scribe area.

In the light-emitting element 10 thus obtained after separation, the part of the sidewall of the buffer layer 22 which coincides with the element end face is exposed while the part receding from the element end face is covered with the insulating film along with the part receding from the element end face of the stepped face.

FIG. 1-1 shows another aspect of (B-i). The example shown in FIG. 1-1 is the light-emitting element 10 where an inter-device separating trench is formed reaching the substrate 21. Element separation by cutting the substrate 21 is conducted within the separating trench. As a result, the sidewall surface of the thin-film crystal layer recedes from the element end face. In this aspect, thin-film crystal layers, particularly the first-conductivity-type semiconductor layer, the active layer structure 25 and the second-conductivity-type semiconductor layer involved in the essential functions such as current injection and light emission are not subjected to common processes such as scribing and braking in element separation, so that the thin-film crystal layers involved in performance is not directly damaged. Thus, the light-emitting element 10 in this aspect is excellent in performance such as tolerance and reliability in large-current injection.

The insulating film (a laminated film consisting of the crystal quality improving layer 30 and the antireflection layer 31) is not formed in the middle of the bottom of the inter-device separating trench as in the example shown in FIG. 1, and the part becomes a scribe area. Since the insulating film is not peeled during element separation in the manufacturing process, reliable insulation can be kept and the thin-film crystal layer is never damaged by tension generated during peeling of the insulating film. When the insulating film is formed as described above, in the light-emitting element after separation, the insulating film does not cover the whole surface of the substrate exposed due to recession of the sidewall surface of the thin-film crystal layer, but covers the inside from the position away from the end of the substrate.

Next, there will be described the aspect (Bii) where an insulating film is away from the bottom of the separating trench. Some examples of the aspect (B-ii) are shown in FIGs. 1-2 and 1-3. This aspect is as described for the aspect (B-i) in terms of the shape of the thin-film crystal layer, layer configuration and so on, but different in the shape of the insulating film in the end of light-emitting element.

Specifically, for example, as shown in FIG. 1-2 which is an example of the light-emitting element 10 which is manufactured such that the inter-device separating trench is formed reaching the substrate 21, an insulating film (a laminated film consisting of the crystal quality improving layer 30 and the antireflection layer 31) is also absent in the surface of the substrate 21 (the bottom of the inter-device separating trench). The part of the sidewall surface receding from the element end face of the thin-film crystal layer which is not covered with an insulating film is present in the side of the substrate 21 of the sidewall surface of the buffer layer 22. When the inter-device separating trench is formed in a part of the substrate 21, the whole sidewall surface of the thin-film crystal layer may be covered with an insulating film.

The part of the buffer layer 22 which is not covered with an insulating film is preferably an undoped layer which is not doped. When the exposed part is made of a highly insulative material, defects such as short circuit due to flowing around of a solder can be prevented and thus a highly reliable light-emitting element can be obtained.

Since an insulating film is not formed in the part contacting with the substrate 21 in the example shown in FIG. 1-2, only the substrate 21 may be scribed and braked during element separation such as scribing and braking in the manufacturing process, so that the thin-film crystal layer is not directly damaged. Furthermore, since the insulating film is not peeled, insulation can be reliably kept and the thin-film crystal layer is not damaged by tension generated during peeling of the insulating film. When the insulating film has the above configuration, in the light-emitting element after separation, the insulating film does not cover the substrate surface exposed due to recession of the sidewall surface in the thin-film crystal layer. Furthermore, as described later, the substrate 21 may be removed in the manufacturing process for a light-emitting element, and the absence of an insulating film in the part contacting with the substrate 21 as described above is preferable because the insulating film is never peeled during removing the substrate 21, too.

It is also preferable in the aspect (B-ii) that the inter-device separating trench is formed to the middle of the buffer layer 22. Here, in a light-emitting element produced, at least the first-conductivity-type semiconductor layer, the active layer structure and the second-conductivity-type semiconductor layer recede inward from the edge of the light-emitting element (the edge of the substrate), and the step formed by the bottom of the separating trench gives a surface parallel to the substrate surface in the edge of the light-emitting element.

FIG. 1-3 shows an example of a light-emitting element 10 where the inter-device separating trench is formed to the middle of the buffer layer 22 in the aspect (B-ii). As shown in the figure, a part of the sidewall surface of the buffer layer 22 coincides with the element end face and from the middle of the buffer layer 22, the sidewall surface recedes from the element end face, so that the buffer layer 22 has a stepped face between the surface coincident with the element end face and the receding sidewall surface. The surface coincident with the element end face and the stepped face in the buffer layer 22 are not covered with an insulating film (a laminated film consisting of the crystal quality improving layer 30 and the antireflection layer 31), and in the sidewall surface receding from the element end face, there is a part without an insulating film in the side of the substrate 21. The part where the insulating film is not formed may be whole of the sidewall surface of the buffer layer 22.

As in the example shown in FIG. 1-3, when the inter-device separating trench is formed to the middle of the buffer layer 22, peeling of the insulating film is reliably prevented because the insulating film covering the sidewall does not reach the edge of the light-emitting element 10 and a highly reliable element like the light-emitting element shown in FIG. 1-2 can be obtained by using a highly insulative material for the exposed layer.

There will be further detailed the structures of the individual members constituting a device.

Substrate

There are no particular restrictions to a material for the substrate 21 as long as it is substantially optically transparent to an emission wavelength of the light-emitting element 10. The term "substantially transparent" means that the substrate does not absorb the light in the emission wavelength or if any, a light output is not decreased by 50 % or more by absorption by the substrate.

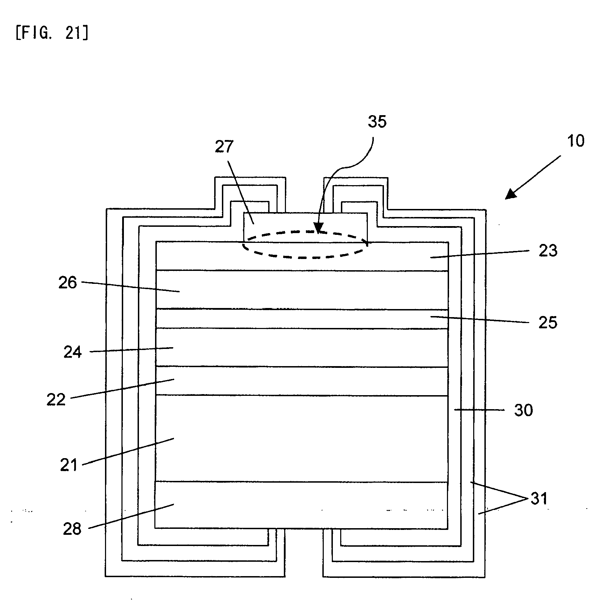

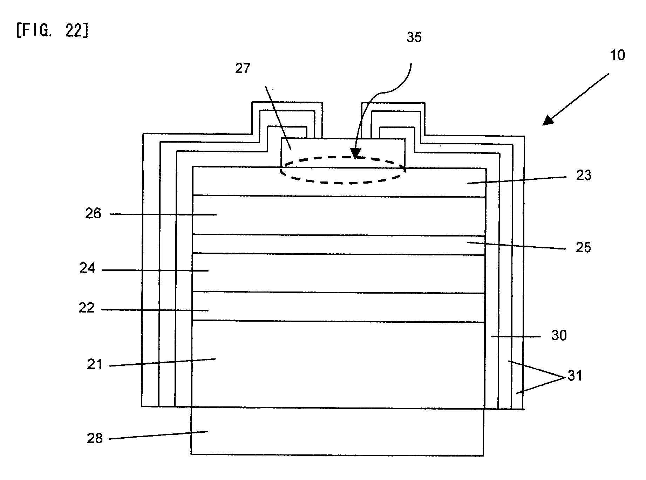

The substrate 21 is preferably an electrically insulative substrate. It is because even if a solder material adheres to the periphery of the substrate 21 during flip-chip mounting the light-emitting element 10, it does not affect current injection into a light-emitting element 10. However, when the light-emitting element 10 is a vertical conduction type described later, the substrate 21 has conductive properties (for example, Figs. 21 and 22). Specific examples of such a material is preferably selected from sapphire ($Al_2O_3$), SiC, GaN, $LiGaO_2$, ZnO, $ScAlMgO_4$, $NdGaO_3$ and MgO, particularly preferably sapphire, GaN substrates for growing a thin-film crystal of an InAlGaN light-emitting material or an InAlBGaN material on the substrate.

The substrate 21 used in the invention may be, in addition to a just-substrate completely defined by a so-called plane index, a so-called off-substrate (miss oriented substrate) in the light of controlling crystallinity during thin-film crystal growth. An off-substrate is widely used as a substrate because it is effective for promoting favorable crystal growth in a step flow mode and thus effective for improving element morphology. For example, when a c+ plane substrate of sapphire is used as a substrate for crystal growth of an InAlGaN material, it is preferable to use a plane inclined to an m+ direction by about 0.2 °. An off-substrate having a small inclination of about 0.1 to 0.2 ° is generally used, but in an InAlGaN material formed on sapphire, a relatively larger off-angle is possible for canceling an electric field due to piezoelectric effect to a quantum well layer as a light-emitting point within an active layer structure 25.

The substrate 21 is also preferably a GaN substrate. GaN has a significantly higher refractive index and a good wave-guiding efficiency compared with the sapphire or the like. Thus, making the side surface extremely low reflectivity by the antireflection layer 31 is very preferable because a light which will exit the thin-film crystal layer to the substrate 21 is more effectively wave-guided to the side surface of the substrate 21 and can be emitted from not the upper surface but the side surface of the substrate 21.

The substrate 21 may be pretreated by chemical etching or heating for manufacturing the light-emitting element 10 utilizing crystal growth technique such as MOCVD and MBE. Alternatively, a plane of the substrate 21 on which the buffer layer 22 is deposited may be deliberately processed to have irregularity in relation to a buffer layer 22 described later to prevent penetrating dislocation generated in an interface between a thin-film crystal layer and the substrate 21 from being introduced near an active layer of a light-emitting-element.

In one embodiment of the present invention, a thickness of the substrate 21 is generally about 350 to

700 $\mu$m in an initial stage of element preparation so as to ensure mechanical strength during crystal growth in the light-emitting element 10 and an element manufacturing process. After growing a thin-film crystal layer, it is desirable that for facilitating separation into individual elements, the substrate is appropriately thinned by a polishing step in the course of the process and finally has a thickness of about 100 $\mu$m or less in a device. The thickness is generally 30 $\mu$m or more.

Furthermore, in another aspect of the present invention, a thickness of the substrate 21 may be thicker than a conventional one. When such a thick substrate is used, an area of the sidewall is effectively increased compared with a light-emitting element having a thinned substrate, so that even when the total radiation flux is substantially equal, the antireflection layer 31 can be allowed to effectively work. That is, in a configuration where the inter-device separating trench reaches the substrate 21 while being formed such that it digs a part of the substrate 21, an insulating film can be also formed in the lateral side of the substrate 21 and through the film, the light extraction amount from the sidewall can be increased, so that the use of a thick substrate 21 is preferable because it consequently allows for reducing outgoing light from the upper side of the substrate surface. In a light-emitting element having such a configuration, a thickness of the substrate 21 is preferably 100 $\mu$m or more, further preferably 150 $\mu$m or more, particularly preferably 250 $\mu$m or more.

Here, since the substrate 21 itself does not contribute to light emitting, it may be removed after all the structural components constituting the light-emitting element 10 such as a thin-film crystal layer and an insulating film are formed. The substrate 21 is, therefore, not an essential member in the present invention.

The substrate 21 can be removed, for example, by attaching the first-conductivity-type-side electrode 28 and the second-conductivity-type-side electrode 27 to a support (not shown) and then peeling the substrate 21 from the thin-film crystal layer. The substrate 21 can be peeled by any appropriate method such as polishing, etching and laser debonding. Furthermore, when an insulating film is formed in contact with the substrate 21, peeling of the substrate 21 may cause peeling of the insulating film, and it is, therefore, preferable to form an insulating film separate from the substrate 21.

Buffer layer

A buffer layer 22 is formed mainly for facilitating thin-film crystal growth, for example, for preventing dislocation, alleviating imperfection in a substrate crystal and reducing various mutual mismatches between a substrate crystal and a desired thin-film crystal growth layer in growing a thin-film crystal on a substrate 21.

The buffer layer 22 is deposited by thin-film crystal growth, and a buffer layer 22 is particularly important since when a material such as an InAlGaN material, an InAlBGaN material, an InGaN material, an AlGaN material, an AlN material and a GaN material is grown on a foreign substrate by thin-film crystal growth, which is a desirable embodiment in the present invention, matching of a lattice constant with a substrate 21 is not necessarily ensured. For example, when a thin-film crystal growth layer is grown by organic metal vapor deposition (MOVPE), a low temperature growth AlN layer at about 600 °C may be used as a buffer layer, or a low temperature growth GaN layer formed at about 500 °C may be used. Even when a material is grown on a coessential substrate by thin-film crystal growth, for example, a material such as an GaN, an AlGaN, an InGaN and an AlInGaN is grown on a GaN substrate, the buffer layer 22 is important. In this case, a material such as AlN, GaN, AlGaN, InAlGaN and InAlBGaN grown at a high temperature of about 800 °C to 1000 °C may be used as the buffer layer 22. These layers are generally as thin as about 5 to 40 nm.

The buffer layer 22 needs not necessarily to be a single layer, and on a GaN buffer layer 22 grown at a low temperature, a GaN layer may be grown at a temperature of about 1000 °C to several $\mu$m without doping for further improving crystallinity. In practice, it is common to form such a thick film buffer layer with a thickness of about 0.5 to 7 $\mu$m. The buffer layer 22 may be doped with, for example, Si, or it may be formed of stacked layers including therein a doped layer and an undoped layer.

A typical embodiment is a two-layer structure of a low temperature buffer layer formed by thin-film crystal growth at a low temperature of about 350 °C to less than 650 °C in contact with a substrate and a high temperature buffer layer formed by thin-film crystal growth at a high temperature of about 650 °C to 1100 °C.

The buffer layer 22 may be formed by epitaxial lateral overgrowth (ELO) as a kind of so-called microchannel epitaxy, which may allow for significant reduction of penetrating dislocation generated between a substrate such as sapphire and an InAlGaN material.

In the present invention, a thickness of the buffer layer 22 effectively increases an area of the sidewall in the light-emitting element 10. Thus, even when the total radiation flux is substantially equal, the antireflection layer 31 is allowed to effectively work, resulting in increase of the light extraction amount from the sidewall through the insulating film, which allows for preventing a light from outgoing from the upper side of the substrate surface, so that a thick buffer layer 22 is preferable. However, since an excessively thicker buffer layer 22 deteriorates crystalline quality of the thin-film crystal layer, a thickness of the buffer layer 22 is preferably 1 $\mu$m to 6 $\mu$m, more preferably 2 $\mu$m to 5 $\mu$m, most preferably 3 $\mu$m to 4 $\mu$m.

First-conductivity-type semiconductor layer and first-conductivity-type cladding layer

In a typical embodiment of the invention, a first-conductivity-type cladding layer 24 is present in contact with a buffer layer 22 as shown in FIG. 1. The first-conductivity-type cladding layer 24 cooperates with a second-conductivity-type cladding layer 26 described later to efficiently inject carriers into an active layer structure 25 described later and to prevent overflow from the active layer structure, for light emission in a quantum well layer with a high efficiency. It also contributes to confinement of light near the active layer structure, for light emission in a quantum well layer with a high efficiency. The first-conductivity-type semiconductor layer includes, in addition to the layer having the above cladding function, a first-conductivity-type doped layer for improving the performance of the element such as a contact layer, or because of manufacturing process. In the broad sense, the whole first-conductivity-type semiconductor layer may be regarded as a first-conductivity-type cladding layer 24, where a contact layer and so on can be regarded as a part of the first-conductivity-type cladding layer 24.

Generally, it is preferable that the first-conductivity-type cladding layer 24 is made of a material having a smaller refractive index than an average refractive index of an active layer structure 25 described later and having a larger band gap than an average band gap of the active layer structure 25 described later. Furthermore, the first-conductivity-type cladding layer 24 is generally made of a material belonging to a type I band lineup in the relation of the active layer structure 25, particularly a barrier layer. Based on such a guideline, the first-conductivity-type cladding layer 24 material can be appropriately selected, considering a substrate 21, a buffer layer 22, an active layer structure 25 and so on provided or prepared for achieving a desired emission wavelength.

For example, when a substrate 21 is C+ plane sapphire and a buffer layer 22 is a stacked structure of GaN grown at a low temperature and GaN grown at a high temperature, the first-conductivity-type cladding layer 24 may be made of a GaN material, an AlGaN material, an AlGaInN material, an InAlBGaN material or a multilayer structure of these.

A carrier concentration of the first-conductivity-type cladding layer 24 is, as a lower limit, preferably $1\times10^{17}$ cm$^{-3}$ or more, more preferably $5\times10^{17}$ cm$^{-3}$ or more, most preferably $1\times10^{18}$ cm$^{-3}$ or more. It is, as an upper limit, preferably $5\times10^{19}$ cm$^{-3}$ or less, more preferably $1\times10^{19}$ cm$^{-3}$ or less, most preferably $7\times10^{18}$ cm$^{-3}$ or less. Here, when the first-conductivity-type is n-type, a dopant is most preferably Si.

Furthermore, in the present invention, a thickness of the first-conductivity-type cladding layer 24 effectively increases an area of the sidewall of the light-emitting element 10. Thus, even when the total radiation flux is substantially equal, the antireflection layer 31 is allowed to effectively work, resulting in increase of the light extraction amount from the sidewall through the insulating film, which allows for preventing a light from outgoing from the upper side of the substrate surface, so that a thick first-conductivity-type cladding layer 24 is preferable. However, since an excessively thicker first-conductivity-type cladding layer 24 deteriorates crystalline quality of the thin-film crystal layer, a thickness of the first-conductivity-type cladding layer 24 is preferably 1 $\mu$m to 10 $\mu$m, more preferably 3 $\mu$m to 8 $\mu$m, most preferably 4 $\mu$m to 6 $\mu$m.

A structure of the first conductivity-type cladding layer 24 is shown as a single-layered first-conductivity-type cladding layer 24 in the example of FIG. 1, but the first-conductivity-type cladding layer 24 may consist of two or more layers. Here, it may be made of, for example, a GaN material and an AlGaN material, an InAlGaN material, or an InAlBGaN material. The whole first-conductivity-type cladding layer 24 may be a superlattice structure as a stacked structure of different materials. Furthermore, within the first-conductivity-type cladding layer 24, the above carrier concentration may be varied.

In the part contacting with the first-conductivity-type-side electrode 28 in the first-conductivity-type cladding layer 24, the carrier concentration may be deliberately increased to reduce a contact resistance with the electrode.

In a preferred structure, a part of the first-conductivity-type cladding layer 24 is etched, and the exposed sidewall and the etched part in the first-conductivity-type cladding layer 24 are completely covered with an insulating layer, except a first current injection region 36 for contact with a first-conductivity-type-side electrode 27 described later.

In addition to the first-conductivity-type cladding layer 24, a further different layer may be, if necessary, present as a first-conductivity-type semiconductor layer. For example, there may be formed a contact layer for facilitating injection of carriers into a junction with an electrode. Alternatively, these layers may be formed as multiple layers different in a composition and formation conditions.

Active layer structure

There is formed the active layer structure 25 on the first-conductivity-type cladding layer 24. An active layer structure 25 means at structure which contains a quantum well layer where the recombination of electrons and holes (or holes and electrons) injected from the above first-conductivity-type cladding layer 24 and a second-conductivity-type cladding layer 26 described later, respectively takes place to emit a light and a barrier layer adjacent to the quantum well layer or between the quantum well layer and a cladding layer. Here, for achieving improvement in an output and efficiency, it is desirable that the equation B = W+1 is satisfied where W is the number of quantum well layers in the active layer structure and B is the number of barrier layers. That is, it is desirable for improving an output that the overall layer relationship between the cladding layers 24, 26 and the active layer structure 25 is "the first-conductivity-type cladding layer, the active layer structure, second-conductivity-type cladding layer" and an active layer structure 25 is configured such as "a barrier layer, a quantum well layer and a barrier layer" or "a barrier layer, a quantum well layer, a barrier layer, a quantum well layer and a barrier layer".

Here, the quantum well layer has a film thickness as small as about a de Broglie wavelength for inducing a quantum size effect to improve a luminous efficiency. Thus, for improving an output, it is desirable to form, instead of forming a single quantum well layer, a plurality of quantum well layers, which are separated to form an active layer structure. Here, a layer controlling binding between the quantum well layers and separating them is a barrier layer. Furthermore, it is desirable that a barrier layer is present for separation between a cladding layer and a quantum well layer. For example, when a cladding layer is made of AlGaN and a quantum well layer is made of InGaN, there is preferably formed a barrier layer made of GaN between them. This is also desirable in terms of thin-film crystal growth because adjustment becomes easier when an optimal temperature for crystal growth is different. When a cladding layer is made of InAlGaN having the largest band gap and a quantum well layer is made of InAlGaN having the smallest band gap, a barrier layer may be made of InAlGaN having an intermediate band gap. Furthermore, a band gap difference between a cladding layer and a quantum well layer is generally larger than a band gap difference between a barrier layer and a quantum well layer; and considering an efficiency of injection of carriers into a quantum well layer, it is desirable that the quantum well layer is not directly adjacent to the cladding layer.

It is preferable that a quantum well layer is not deliberately doped. On the other hand, it is desirable that a barrier layer is doped to reduce a resistance of the overall system. In particular, it is desirable that a barrier layer is doped with an n-type dopant, particularly Si. Mg as a p-type dopant easily diffuses in a device and it is thus important to minimize Mg diffusion during high output operation. Thus, Si is effective and it is desirable that the barrier layer is Si-doped. It is, however, desirable that the interface between the quantum well layer and the barrier layer is undoped.

Second-conductivity-type semiconductor layer and second-conductivity-type cladding layer

The second-conductivity-type cladding layer 26 cooperates with the first-conductivity-type cladding layer 24 described above to efficiently inject carriers into the active layer structure 25 described above and to prevent overflow from the active layer structure, for light emission in a quantum well layer with a high efficiency. It also contributes to confinement of light near the active layer structure, for light emission in a quantum well layer with a high efficiency. The second-conductivity-type semiconductor layer includes, in addition to the layer having the above cladding function, a second-conductivity-type doped layer for improving the performance of the element such as a contact layer or because of manufacturing process. In the broad sense, the whole second-conductivity-type semiconductor-layer may be regarded as a second-conductivity-type cladding layer 26, where a contact layer and so on can be regarded as a part of the second-conductivity-type cladding layer 26.

Generally, it is preferable that the second-conductivity-type cladding layer 26 is made of a material having a smaller refractive index than an average refractive index of an active layer structure 25 described above and having a larger band gap than an average band gap of the active layer structure 25 described above. Furthermore, the second-conductivity-type cladding layer 26 is generally made of a material belonging to a type I band lineup in relation to the active layer structure 25, particularly a barrier layer. Based on such a guideline, the second-conductivity-type cladding layer 26 material can be appropriately selected, considering a substrate 21, a buffer layer 22, an active layer structure 25 and so on provided or prepared for achieving a desired emission wavelength. For example, when a substrate 21 is C+ plane sapphire and a buffer layer 22 is made of GaN, the second-conductivity-type cladding layer 26 may be made of a GaN material, an AlGaN material, an AlGaInN material, an AlGaBInN material or the like. It may be a stacked structure of the above materials. Furthermore, the first-conductivity-type cladding layer 24 and the second-conductivity-type cladding layer 26 may be made of the same material.

A carrier concentration of the second-conductivity-type cladding layer is, as a lower limit of, preferably $1\times10^{17}$ cm$^{-3}$ or more, more preferably $4\times10^{17}$ cm$^{-3}$ or more, further preferably $5\times10^{17}$ cm$^{-3}$ or more, most preferably $7\times10^{17}$ cm$^{-3}$ or more. It is, as an upper limit, preferably $7\times10^{18}$ cm$^{-3}$ or less, more preferably $3\times10^{18}$ cm$^{-3}$ or less, most preferably $2\times10^{18}$ cm$^{-3}$ or less. Here, when the second-conductivity-type is p-type, a dopant is most preferably Mg.

A structure of the second-conductivity-type cladding layer 26 is shown as a single layer in the example of FIG. 1, but the second-conductivity-type cladding layer 26 may consist of two or more layers. Here, it may be made of, for example, a GaN material and an AlGaN material. The whole second-conductivity-type cladding layer 26 may be a superlattice structure as a stacked structure of different materials. Furthermore, within the second-conductivity-type cladding layer 26, the above carrier concentration may be varied.

Generally, in a GaN material, when an n-type dopant is Si and a p-type dopant is Mg, p-type GaN, p-type AlGaN and p-type AlInGaN are inferior to n-type GaN, n-type AlGaN and n-type AlInGaN, respectively, in crystallinity. Thus, in manufacturing an element, it is desirable that a p-type cladding layer with inferior crystallinity is formed after crystal growth of an active layer structure 25, and in this regard, it is desirable that the first-conductivity-type is n-type while the second-conductivity-type is p-type.

A thickness of the p-type cladding layer with inferior crystallinity (this corresponds to a second-conductivity-type cladding layer 26 in an preferred embodiment) is preferably thinner to some extent. However, since an extremely thin layer lead to reduction in a carrier injection efficiency, there is an optimal value. A thickness of the second-conductivity-type-side cladding layer 26 can be appropriately selected, but is preferably 0.05 $\mu$m to 0.3 $\mu$m, most preferably 0.1 $\mu$m to 0.2 $\mu$m.

In the part contacting with the second-conductivity-type-side electrode 27 in the second-conductivity-type cladding layer 26, its carrier concentration may be deliberately increased to reduce a contact resistance with the electrode.

It is desirable that the exposed sidewall in the second-conductivity-type cladding layer 26 is completely covered with an insulating layer, except a second current injection region 35 for contact with a second-conductivity-type-side electrode 27 described later.

As described above, it is desirable that the second-conductivity-type cladding layer 26 is a p-type layer, which is also desirable in that in such a case, the crystal quality improving layer 30 can be prominently effective. That is, the crystal quality improving layer 30 itself contains, as described later, nitrogen and during the process for forming it, active nitrogen is also supplied to the surface of the thin-film crystal layer, so that it can be nitrogen source for a thin-film crystal layer with nitrogen being eliminated after various steps for manufacturing an element and thus would prevent microscopic deviation from a stoichiometric composition and improve crystallinity. Alternatively, it could produce a crystal-quality improving effect by terminating a dangling bond (uncombined hand) of an element constituting a damaged thin-film crystal layer (termination effect). By such effects, the p-type layer is also expected to prevent/recover reduction in a hole concentration in the element surface after various steps for manufacturing an element including the step of film crystal growth.

Furthermore, in addition to the second-conductivity-type cladding layer 26, a further different layer may be, if necessary, present as a second-conductivity-type semiconductor layer. For example, there may be formed a contact layer for facilitating injection of carriers into a part contacting with an electrode. Alternatively, these layers may be formed as multiple layers different in a composition and preparation conditions.

The surface of the second-conductivity-type semiconductor layer can contain at least Mg and H.

Without departing from the scope of the present invention, a layer which does not belong to the above category may be, if necessary, formed as a thin-film crystal layer.

Second-conductivity-type-side electrode

A second-conductivity-type-side electrode 27 achieves good ohmic contact with a second-conductivity-type nitride compound semiconductor, and has good adhesion to a submount 40 by a solder material in flip-chip mounting. For this end, a material can be appropriately selected and the second-conductivity-type-side electrode 27 may be either single-layered or multi-layered. Generally, for achieving a plurality of required purposes to an electrode, a plurality of layer configurations are preferred.

When the second-conductivity-type is p-type and a portion of the second-conductivity-type cladding layer 26 that faces to the second-conductivity-type-side electrode 27 is formed of GaN, a material for the second-conductivity-type-side electrode 27 is preferably a material comprising Ni, Pt, Pd, Mo, Au or two or more elements of these. This electrode may be of a multilayer structure, where at least one layer is made of a material comprising the above element, and preferably each layer is made of a material comprising the above element and having a different constituting component (type and/or ratio). A constituent material for the electrode is preferably an elemental metal or an alloy.

In a particularly preferable embodiment, the first layer, which faces to the p-side cladding layer, of the second-conductivity-type-side electrode 27 is Ni and the surface of the opposite side to the p-side cladding layer side of the second-conductivity-type-side electrode 27 is Au. This is because Ni has a work function with a large absolute value which is favorable for a p-type material and Au is preferable as the outermost surface material in the light of tolerance to process damage described later and a mounting sequence.

The second-conductivity-type-side electrode 27 can contact with any of the thin-film crystal layers as long as second-conductivity-type carriers can be injected, and for example, when a second-conductivity-type-side contact layer is formed, the electrode is formed in contact with the layer.

First-conductivity-type-side electrode

A first-conductivity-type-side electrode 28 achieves good ohmic contact with a first-conductivity-type nitride compound semiconductor, and has good adhesion to a submount 40 by a solder material in flip-chip mounting, and for this end, a material can be appropriately selected. The first-conductivity-type-side electrode 28 may be either single-layered or multi-layered. Generally, for achieving a plurality of required purposes to an electrode, a plurality of layer configurations are preferred.

When the first-conductivity-type is n-type, an n-side electrode is preferably made of a material comprising any of Ti, Al, Ag and Mo or two or more of these. This electrode may be in the form of a multilayer structure, where at least one layer is made of a material comprising the above element, and preferably each layer is made of a material comprising the above element and having a different constituting component (type and/or ratio). A constituent material for the electrode is preferably an elemental-metal or an alloy. This is because these metals have a work function with a small absolute value.

In the present invention, it is preferred that the first-conductivity-type-side electrode 28 is formed so as to have the larger area than the first current injection region 36, and that the first-conductivity-type-side electrode 28 and the second-conductivity-type-side electrode 27 do not spatially overlap at all. This is important for ensuring an adequate area to ensure adequate adhesiveness to a submount 40 during flip-chip mounting a light-emitting-element 10 by soldering while ensuring an adequate distance for preventing unintended short circuit due to, for example, a solder material between the second-conductivity-type-side electrode 27 and first-conductivity-type-side electrode 28.

The first-conductivity-type-side electrode 28 can contact with any of the thin-film crystal layers as long as first-conductivity-type carriers can be injected, and for example, when a first-conductivity-type-side contact layer is formed, the electrode is formed in contact with this layer.

Insulating film

An insulating film is preferably a multilayer film in which the first layer is the' crystal quality improving layer 30 and the second and the subsequent layers are at least one antireflection layer 31. When the insulating film is such a multilayer film, the crystal quality improving layer 30 and the antireflection layer 31 are continuously formed in the same deposition apparatus in the light of productivity improvement and reliability assurance of the light-emitting element.

The crystal quality improving layer 30 is a layer formed for improvement of crystallinity and recovery from damage in the surface of the thin-film crystal layer. The crystal quality improving layer 30 would be effective for crystal quality improvement by, for example, minimizing microscopic deviation from a stoichiometric composition as one of the causes of damage in a thin-film crystal layer and improving its crystallinity. Alternatively, it could produce a crystal-quality improving effect by terminating a dangling bond (uncombined hand) of an element constituting a damaged thin-film crystal layer (termination effect).

Without being limited to the above mechanism of the improving effect by the crystal quality improving layer 30, an objective of the present invention can be more satisfactorily achieved by appropriately selecting a material for the crystal quality improving layer.

In the thin-film crystal layer, an element having a higher vapor pressure among the elements constituting the thin-film crystal layer may be eliminated during the process for forming the layer or later. It would be thus preferable that when the crystal quality improving layer 30 is formed, an element having a higher vapor pressure among the elements constituting the thin-film crystal layer is supplied after being activated by, for example, plasma conversion. Since a thin-film crystal layer is generally made of, for example, a GaN material, nitrogen constituting a thin-film crystal layer which has a high vapor pressure and tends to be eliminated is preferably supplied from the crystal quality improving layer 30.

For example, when a GaN thin-film crystal layer is formed by crystal growth by MOCVD, nitrogen is eliminated from the surface of the thin-film crystal layer or sometimes the lateral side of the thin-film crystal layer during the process for forming the thin-film crystal layer or a later process. Thus, the crystal quality improving layer 30 itself contains nitrogen and during the process for forming it, relatively active nitrogen is also supplied to the surface of the thin-film crystal layer or other exposed surface such as a lateral side, so that it can be nitrogen source for a thin-film crystal layer with nitrogen being eliminated due to various steps for manufacturing an element and thus would prevent microscopic deviation from a stoichiometric composition and improve crystallinity. Furthermore, such crystallinity improvement is expected to be effective in improving a carrier activation rate in the part of the thin-film crystal layer in contact with the crystal quality improving layer 30 or the part of the thin-film crystal layer exposed to relatively active nitrogen supplied during forming the crystal quality improving layer 30. Furthermore, the crystal quality improving layer 30 is expected to be effective in recovery from damage unintentionally generated in the sidewall, the surface and the like of the element structure in the course of manufacturing the light-emitting element. In particular, the effect would be prominent in, for example, improving a PL (Photo Luminescence) intensity and a carrier concentration in the thin-film crystal layer.

When the thin-film crystal layer is made of a nitride, the crystal quality improving layer 30 preferably contains nitrogen and hydrogen for playing the above role and the crystal quality improving layer 30 is preferably formed while both relatively active nitrogen and hydrogen are supplied as starting materials. When the thin-film crystal layer is made of an oxynitride, the crystal quality improving layer 30 preferably contains nitrogen and oxygen and the crystal quality improving layer 30 is preferably formed while both relatively active nitrogen and relatively active oxygen are supplied as starting materials.

From that viewpoint, a material for the crystal quality improving layer 30 preferably contains nitride and/or oxynitride, more preferably a nitride and/or an oxynitride containing at least one or more elements of B, Al, Si, Ti, V, Cr, Mo, Hf, Ta and W. Examples of such a nitride and an oxynitride may include $AlN_x$, $AlO_xN_y$, $SiN_x$, $SiO_xN_y$, $TiN_x$, $TiO_xN_y$, $CrN_x$ and $CrO_xN_y$. Among others, $SiN_x$ and $SiO_xN_y$ are very preferable. In the above composition formula, x and y represent an arbitrary positive number.

As described above it is probable that, for example, when the thin-film crystal layer contains a nitride and/or oxynitride, the crystal quality improving layer 30 contains nitrogen and thus becomes a nitrogen source to the thin-film crystal layer with nitrogen being eliminated, resulting in improvement in crystallinity of the thin-film crystal layer. Furthermore, since a nitrogen source to the thin-film crystal layer is formed as a layer, crystallinity of the thin-film crystal layer could be stably improved longer than the case where, for example, nitrogen elimination is compensated by treating the surface of the thin-film crystal layer with ammonia. It is, therefore, preferable that when a GaN material is used for the thin-film crystal layer which is a preferable embodiment in the present invention, the crystal quality improving layer contains a nitride and/or an oxynitride. Among others, a preferable nitride or oxynitride can be appropriately selected in the light of the followings.

First, a nitride such as $SiN_x$ is preferable when a main function of the layer is a nitrogen source to the thin-film crystal layer with nitrogen being eliminated. In other words, for improvement of PL intensity or significant improvement in crystal quality of the thin-film crystal layer, a nitride is preferably selected as the crystal quality improving layer 30.

On the other hand, when a main purpose is making the whole insulating film less reflective; an oxynitride such as $SiO_xN_y$ is preferably selected. It is because when the thin-film crystal layer is made of a GaN material, a refractive index can be adjusted by adjusting a ratio of O/N for making the whole insulating film including the crystal quality improving layer 30 less reflective to a light emitted from the inside of the light-emitting element. In this case, our investigation has indicated that this type is preferable because it is useful for optical design of an insulating film for a practical light-emitting element owing to a broader adjustment range of a refractive index although its crystal quality improving effect is less than a nitride such as $SiN_x$. Furthermore, when an oxynitride such as $SiO_xN_y$ is selected, an insulating film may be made of the oxynitride alone to produce the effects of both of the crystal quality improving layer 30 and the antireflection layer 31 described later, depending on an extent of refractive index adjustment.

On the other hand, when a thin-film crystal layer contains a different material type, that it, an oxide oxynitride, crystallinity of the thin-film crystal layer can be improved by, for example, forming a crystal quality improving layer 30 containing an oxide, which can be used as an oxygen source. Examples of such an oxide or oxynitride may include $AlO_xN_y$, $SiO_xN_y$, $TiO_xN_y$ and $CrO_xN_y$. In the above composition formula, x and y are arbitrary positive numbers.

In a thin-film crystal layer, there may exist the ends of dangling bond (uncombined hand) at a high density in the outermost surface of the thin-film crystal layer during formation of the layer or a later process. In such a case, the crystal quality improving layer 30 preferably contains an element prominently producing terminal effect. Examples of an element producing terminal effect may include Si, Ge, Se, S, Al, P and As. Among them, Si, Ge, Se and S are preferable and Si is further preferable.

When the crystal quality improving layer 30 contains the above element as an elementary substance, it is preferable that the element producing terminal effect itself has dangling bonds to some extent, which tend to bind to substrate-side dangling bonds on the surface of the processed substrate. Therefore, although the element as an elementary substance may be effective to some extent even when it is polycrystalline or monocrystalline, it is most preferably amorphous.

In terms of the materials for forming the crystal quality improving layer 30, a nitrogen source is preferably a gas species containing at least ammonia, and an oxygen source is preferably a gas species containing at least $N_2O$. The crystal quality improving layer 30 can be formed by any of various deposition methods such as plasma CVD, ion plating, ion assisted deposition and ion-beam sputtering. A method for forming the crystal quality improving layer 30 is preferably a method in which the starting materials can be supplied relatively active materials during forming the crystal quality improving layer 30.

The term, "an active starting material" as used herein collectively refers to chemical species which is not in a chemically stable molecular state, that is, the starting material itself becomes a radical, plasma, ion or optionally atom.

For example, it is desirable in plasma CVD that ammonia ($NH_3$) is used as a source gas and $SiN_x$ is formed. Here, $NH_3$ is converted into plasma to provide relatively active nitrogen and hydrogen while a crystal quality improving layer is formed. Also, in ion assisted deposition, a Si material can be deposited while, for example, $NH_3$ is converted into plasma using an ion gun to produce $SiN_x$. In ion-beam sputtering, for example, a Si target is sputtered by Ar or $N_2$ while, for example, $NH_3$ is converted into plasma using an ion gun to produce $SiN_x$. Also, in RF sputtering, for example, a $SiN_x$ target can be sputtered by Ar or $N_2$ while $N_2$ and $H_2$ are independently supplied as plasma using an ion gun to produce $SiN_x$.

Plasma CVD is most preferable among these methods for forming the crystal quality improving layer 30 while supplying both relatively active nitrogen and hydrogen as source materials. It is because in comparison with the other deposition methods, the method is favorable for covering a desired part in the light-emitting element structure owing to satisfactory step coverage and easiness in stress control within the film.

Although a nitrogen-containing film with a hydrogen content being relatively smaller can be also formed by reactive sputtering in which while $N_2$ gas is introduced, an Si target is sputtered by, for example, Ar to form an SiNx film in $N_2$ or Ar plasma, it is substantially ineffective in improving the quality of the thin-film crystal layer, that is, improving PL intensity of the thin-film crystal layer. In contrast, a concentration of hydrogen atoms is high in a film formed by plasma CVD while, for example, $NH_3$ is introduced as a starting material or a film formed by separately supplying $H_2$ and $N_2$ plasma, and our experiment described later has indicated the effect of improvement in PL intensity of a thin-film crystal layer. This is attributed to the fact that active nitrogen which would directly influence the effect of improving crystal quality is incorporated into a thin-film crystal layer and the crystal quality improving layer 30 so that active hydrogen derived from $NH_3$ is also incorporated at the same time. Direct effects of active hydrogen may include, but not clearly understood, cleaning of an element surface contaminated after various processes, terminating dangling bonds present in/near the surface of the thin-film crystal layer and reducing an excessive internal stress in the film. However, supply of excessively active atomic hydrogen is undesirable because, for example, carrier inactivation is accelerated when a second-conductivity-type-side semiconductor layer is a Mg-doped p-type layer.

In our investigation, specifically in repeated experiments where a film was deposited by various deposition procedures under various deposition conditions by a method in which neither relatively active nitrogen nor hydrogen is supplied as a starting material, for example, reactive sputtering in which $N_2$ gas is introduced before an Si target is sputtered with Ar gas and the deposited $SiN_x$ films were measured for a concentration of hydrogen atoms, hydrogen was detected in a low level of $10^{20}$ atoms/cm$^3$ in any film. The hydrogen would be derived from water remaining in the deposition atmosphere.

In contrast, in an $SiN_x$ film deposited by plasma CVD where both relatively active nitrogen and hydrogen were supplied as a starting material, for example, $NH_3$ was introduced as a starting material or in an $SiN_x$ film deposited while $N_2$ and $H_2$ separately converted into plasma were supplied, a deposition experiment was repeated under various deposition conditions and the obtained $SiN_x$ films were measured for a concentration of hydrogen atoms. As a result, even when the deposition conditions were varied, a hydrogen-atom concentration was constantly $1 \times 10^{21}$ atoms/cm$^3$ or more and $1 \times 10^{22}$ atoms/cm$^3$ or less. This would be because $NH_3$ or $H_2$ and $N_2$ as one of the starting materials, was converted into plasma which contained both relatively active nitrogen and hydrogen and the hydrogen was incorporated into the above $SiN_x$ film as an evidence of the use of the relatively active hydrogen during the deposition.

Furthermore, in an $SiN_x$ film deposited by plasma CVD where both relatively active nitrogen and hydrogen were supplied as a starting material, for example, $NH_3$ was introduced as a starting material or in an SiNx film deposited while $N_2$ and $H_2$ separately converted into plasma were supplied, a deposition experiment was repeated under various deposition conditions and in the evaluation of the crystal quality of the thin-film crystal layer after $SiN_x$ deposition on the basis of PL intensity, a hydrogen-atom concentration in the $SiN_x$ film when PL intensity of the thin-film crystal layer was improved by 10 % or more was measured, and as a result, the hydrogen-atom concentration was constantly $2 \times 10^{21}$ atoms/cm$^3$ or more and $7 \times 10^{21}$ atoms/cm$^3$ or less. Furthermore, a hydrogen-atom concentration in the $SiN_x$ film when PL intensity of the thin-film crystal layer was improved by 30 % or more was measured, and as a result, the hydrogen-atom concentration was constantly $3 \times 10^{21}$ atoms/cm$^3$ or more and $5 \times 10^{21}$ atoms/cm$^3$ or less.

Therefore, a hydrogen-atom concentration in the crystal quality improving layer 30 is, but not limited to, preferably $1 \times 10^{21}$ atoms/cm$^3$ or more and $1 \times 10^{22}$ atoms/cm$^3$ or less, more preferably $2 \times 10^{21}$ atoms/cm$^3$ or more and $7 \times 10^{21}$ atoms/cm$^3$ or less. Most preferably, it is $3 \times 10^{21}$ atoms/cm$^3$ or more and $5 \times 10^{21}$ atoms/cm$^3$ or less. Like hydrogen atoms, a nitrogen-atom concentration in the crystal quality improving layer 30 is, but not limited to, preferably 30 atomic% or more and 60 atomic% or less, more preferably preferably 40 atomic% or more and 50 atomic% or less.

A hydrogen-atom concentration in a film is measured by SIMS (Secondary Ion Mass Spectroscopy) while a nitrogen-atom concentration is measured by XPS (X-ray Photoelectron Spectroscopy), and a measurement error may be about $\pm$ 20 % in SIMS and about $\pm$ 30 % in XPS. In either method, low-energy ion milling is combined to determine a profile in a film-depth direction, from which a concentration is estimated.

Depending on, for example, difference in a hydrogen-atom concentration, the feature of an $SiN_x$ film which can be used as the crystal quality improving layer 30 is reflected in its refractive index. First, both relatively active nitrogen and hydrogen were supplied as a starting material to form an $SiN_x$ film which can be used as the crystal quality improving layer 30. Specifically, experiments conducting film deposition by, for example, plasma CVD in which $NH_3$ is introduced as a starting material were repeated, and for the $SiN_x$ films obtained, a refractive index was measured. Then, even when the production conditions and the deposition conditions were varied, a refractive index was 1.80 or more and 2.00 or less at a wavelength of 405 nm and 1.75 or more and 1.95 or less at a wavelength of 633 nm. This would be because $NH_3$, one of the starting materials, was converted into plasma which contained both relatively active nitrogen and hydrogen and the hydrogen was incorporated into the above $SiN_x$ film as an evidence of the use of the relatively active hydrogen during the deposition, giving a film with a lower refractive index in comparison with a film without active hydrogen.

The feature of an $SiO_xN_y$ film which can be used as the crystal quality improving layer 30 is also reflected in its refractive index. The inventers repeated experiments forming an $SiO_xN_y$ film in which both relatively active nitrogen and relatively active oxygen were supplied as a starting material by converting $N_2O$ and $NH_3$ as source gases into plasma by various manufacturing procedures under various deposition conditions, and for the $SiO_xN_y$ films obtained which could be used as the crystal quality improving layer 30, a refractive index was measured. Then, when the production conditions and the deposition conditions were varied, a refractive index was 1.45 or more and 1.90 or less at wavelengths of 405 nm and 633 nm. The refractive index is lower than that of the $SiN_x$ film, indicating that $N_2O$, one of the starting materials; was converted into plasma and oxygen was used as a starting material during film deposition.

Furthermore, it has been observed from our investigation that the use of an $SiO_xN_y$ film as the crystal quality improving layer 30 can result in improved crystal quality in comparison with the case where a simple oxide such as $SiO_x$ is formed such that it corresponds to the crystal quality improving layer, even when an N concentration is low. This would be because the effect of improving crystal quality is produced by depositing an $SiO_xN_y$ film under the atmosphere containing activated nitrogen by supplying, for example, $NH_3$ as a source gas even under the conditions where a less amount of nitrogen is incorporated into the crystal quality improving layer formed.

On the other hand, as described above, for an $SiN_x$ film not acting as a crystal quality improving layer which is formed by a method where neither relatively active nitrogen nor hydrogen is supplied as a starting material, for example, reactive sputtering where while $N_2$ gas is introduced, an Si target is sputtered with Ar gas, experiments were repeated by various deposition procedures under various deposition conditions and for the $SiN_x$ films produced, a refractive index was measured. Then, a refractive index of the $SiN_x$ was more than 2.00 and 2.15 or less at a wavelength of 405 nm and more than 1.95 and 2.10 or less at a wavelength of 633 nm.

Therefore, a refractive index of the crystal quality improving layer 30 is, but not limited to, preferably 1.80 or more and 2.00 or less at a wavelength of 405 nm and 1.75 or more and 1.95 or less at a wavelength of 633 nm for a nitride. For an oxynitride, a refractive index is preferably 1.45 or more and 1.90 or less at a wavelength of 405 nm and also 1.45 or more and 1.90 or less at a wavelength of 633 nm.

The antireflection layer 31 is a layer for reducing a reflectance of an incident light from the side of the thin-film crystal layer to the side of the insulating film. Specifically, when a light generated in the thin-film crystal layer vertically enters the insulating film, preferably R < 3 %, more preferably R < 1 %, most preferably R < 0.2 % wherein R is defined as a light reflectance for the whole insulating film (hereinafter, sometimes simply referred to as "an insulating-film reflectance"). An insulating-film reflectance can be adjusted by appropriately selecting a material and a film thickness of the crystal quality improving layer 30 and the antireflection layer 31, and, in particular, is considerably dependent on a film thickness of the antireflection layer 31. Therefore, an insulating-film reflectance can be preferably adjusted by varying a film thickness of the antireflection layer 31.

When an oxynitride such as $SiO_xN_y$ is used as the crystal quality improving layer 30, a component ratio of O to N can be varied by, for example, adjusting a flow-rate ratio of $N_2O/NH_3$ supplied, to adjust a refractive index of the insulating film. Thus, for $SiO_xN_y$, an insulating-film reflectance can be adjusted as a result of varying a refractive index.

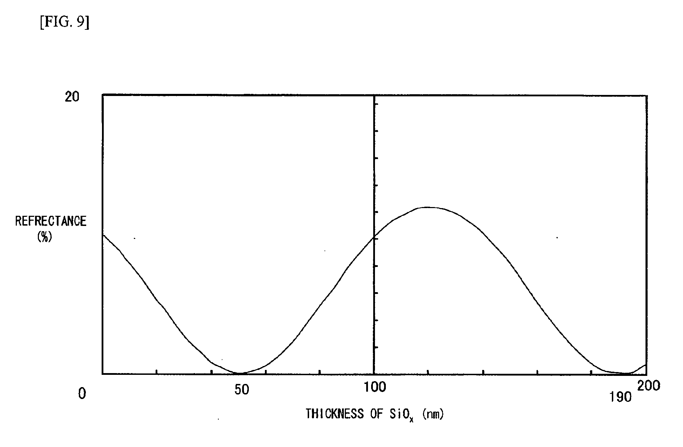

An insulating-film reflectance generally tends to periodically vary in response to a film thickness of the antireflection layer 31. FIG. 9 is a graph showing relationship between a film thickness and a reflectance of $SiO_x$ when $SiO_x$ is deposited by plasma CVD on $SiN_x$ with a film thickness of 30 nm over a thin-film crystal layer. Here, at an either $SiO_x$ thickness of 50 nm and 190 nm, a reflectance is 0.02 %. In such a case, if a reflectance for the whole insulating film is equal, a thinner film thickness of the antireflection layer 31 is preferable. It is because the thinner antireflection layer 31 exhibits better heat dissipation from a light-emitting element and thus it is preferable to select a smaller total thickness of the insulating film.

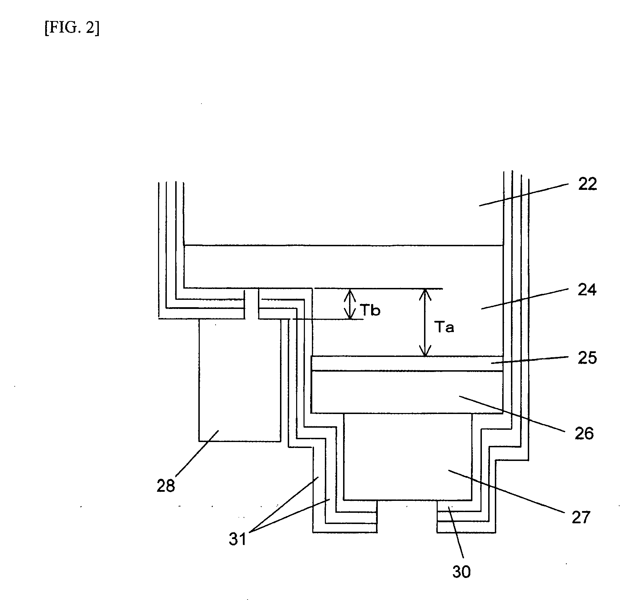

The total thickness of the insulating film is preferably determined, taking the following restrictions into account. As shown in FIG. 1, the insulating film is disposed between the first-conductivity-type-side electrode 28 and the first-conductivity-type cladding layer 24, and defines the first current injection area 36. Here, when the insulating film has an excessively large total thickness, a light emitted from the active layer structure 25 to a left-lateral direction of FIG. 1 in the paper (a direction toward the first-conductivity-type-side electrode 28) horizontally enters each layer constituting the insulating film, so that in this part, reflection-restricting effect may not be adequately produced. As shown in FIG. 2, it is, therefore, preferable that in terms of the active layer structure, the layer finally formed (the uppermost layer) in the insulating film, that is, the layer directly in contact with the first-conductivity-type-side electrode 28 (the uppermost layer) is closer to the side of the buffer layer 22 than the first-conductivity-type-side cladding layer 24 in the active layer structure 25.

Here, it is, as shown in FIG. 2, preferable that Ta and Tb has the following relationship:

$$Ta>Tb$$

wherein Ta is a length from the part of the first-conductivity-type cladding layer 24 exposed by the first etching step described layer to the part where the first-conductivity-type cladding layer 24 is in contact with the active layer structure 25 and Tb is a thickness of the insulating film formed in a part of the first-conductivity-type cladding layer 24 exposed by the first etching step described later.

Furthermore, the uppermost layer in the insulating film is, as described later, preferably made of $SiN_x$ for controlling a shape formed after wet etching.

There are no particular restrictions to the lower limit to an insulating-film reflectance R, and it may be theoretically more than zero and practically is more than 0.001 %.

For achieving a very small insulating-film reflectance, the antireflection layer 31 is preferably made of a material selected from $AlO_x$, $SiO_x$, $TiO_x$, $MgF_2$, $SiN_x$ and $SiO_xN_y$.

For example, when a monolayer $SiN_x$ film is formed as an insulating film on GaN and a light having a wavelength of 405 nm is vertically introduced to the $SiN_x$ film from the GaN side, a light reflectance in the $SiN_x$ film is theoretically no less than 3 %. However, by further forming an $SiO_x$ film on the $SiN_x$ film to be a crystal quality improving layer, a quite low reflectance of 0.02 % may be achieved, depending on its film thickness. Furthermore, when an $SiO_xN_y$ film is formed as an insulating film on GaN and the light is vertically introduced to the $SiO_xN_y$ film from the GaN side, a low reflectance can be achieved by making a refractive index of $SiO_xN_y$ very close to a square root of a product of a refractive index of the GaN and a refractive index of a medium surrounding the GaN light-emitting element at a light-emitting wavelength of the light-emitting element. Specifically, when a refractive index of the GaN is 2.55, the surrounding medium is air, a refractive index of air is 1 and $SiO_xN_y$ is formed as an insulating film, a very small reflectance can be achieved by making its refractive index close to $(2.55 \times 1)^{1/2} \approx 1.597$. Furthermore, when a refractive index of the GaN is 2.55, the surrounding medium is a so-called silicone resin, a refractive index of the silicone resin is 1.40 and $SiO_xN_y$ is formed as an insulating film, a very small reflectance can be achieved by making its refractive index close to $(2.55 \times 1.40)^{1/2} \approx 1.889$.

By making an insulating-film reflectance very low by the antireflection layer 31, in the part where the antireflection layer 31 is formed, most of a light generated in the thin-film crystal layer can be transmitted through the antireflection layer 31 and extracted to the outside of the light-emitting element 10. Thus, in contrast to a conventional light-emitting element where a light is to be extracted only from the substrate side by making an insulating film reflective, a spatial radiant flux density or an energy density above the semiconductor light-emitting element (or the opposite side to a reflection electrode in, for example, an element without a substrate) without varying light quantity as a whole. Consequently, in a luminescence source having the light-emitting element 10 and a phosphor, deterioration in the phosphor is prevented and thus reliability of the luminescence source is improved when the above light-emitting element is used as a phosphor-exciting light source. Furthermore, when the luminescence source gives white light by mixing blue light from a blue phosphor, green light from a green phosphor and red light from a red phosphor, variation in chromaticity, a color temperature or the like due to difference in an extent of deterioration in the individual color phosphors can be prevented.

Such an effect of preventing deterioration in a phosphor is particularly effective when the light-emitting element 10 is an element emitting UV light or near-ultraviolet light with a high spatial energy density. In this sense, the light-emitting element 10 desirably meets the condition of Formula 1 wherein a central wavelength of the light emitted from the active layer structure 25 is $\lambda$ (nm), and here, the effect of the antireflection layer 31 is more effective.

$$300 \text{ nm} \le \lambda \le 430 \text{ nm} \cdots \text{Formula 1}$$

A GaN thin-film crystal layer has an inherent property that it absorbs a light with a shorter wavelength than a light corresponding to its bandgap (a light with a central wavelength $\lambda$ of less than 363 nm). On the other hand, for a light with a central wavelength $\lambda$ of more than 363 nm, the longer the wavelength is, the more transparent the GaN thin-film crystal layer is, so that extrinsic absorption due to, for example, deterioration or damage in the thin-film crystal layer tends to be relatively larger, and with the central wavelength $\lambda$ of 390 nm or more, the tendency is prominent. Therefore, for reducing an optical loss of a light generated in the thin-film crystal layer and efficiently extracting the light outside of the light-emitting element 10 after transmission through the antireflection layer 31, a central wavelength $\lambda$ (nm) of the light desirably meets the condition of Formula 2, more desirably meets the condition of Formula 3.

$$363 \text{ nm} \le \lambda \le 430 \text{ nm} \cdots \text{Formula 2}$$

$$390 \text{ nm} \le \lambda \le 430 \text{ nm} \cdots \text{Formula 3}$$

Although FIG. 1 shows an example in which the antireflection layer 31 has a two-layer structure, the antireflection layer 31 may have a monolayer or three or more layer structure.

Submount

A submount 40 has a metal layer and performs functions of current injection into a flip-chip mounted light-emitting element 10 and heat dissipation. A base material of the submount 40 is preferably a metal, AlN, SiC, diamond, BN or CuW. These materials are desirable because they exhibit good heat dissipation properties and can efficiently prevent the problem of heat generation which is inevitable in a high-output light-emitting-element 10. Furthermore, $Al_2O_3$, Si, glasses and so on are also preferable because they are inexpensive and can be used as a base material for a submount 40 in a wide variety of applications. When a base material for the submount is selected from metals, its periphery is preferably covered with, for example, a dielectric material which is etching resistant.

A light-emitting element 10 is bonded to a metal layer on a submount 40 via any of various solder materials and paste materials. For adequately ensuring heat dissipation properties for high output operation and highly efficient light emission of the light-emitting element 10, bonding via a metal solder is particularly preferable. Examples of a metal solder include In, InAg, PbSn, SnAg, AuSn, AuGe and AuSi. These solders are stable and can be appropriately selected in the light of the environmental conditions such as a working temperature.

A surface of the submount has preferably a higher reflectance property for an emission wavelength rage of a light from the light-emitting element.

Although a semiconductor light-emitting element having a flip-chip type structure has been described as a preferable embodiment of the present invention, a semiconductor light-emitting element having a so-called vertical conduction type structure may be another embodiment of the present invention.

As shown in FIGs. 21 and 22, a semiconductor light-emitting element (light-emitting element 10) having a vertical conduction type structure has a substrate 21 and a compound semiconductor thin-film crystal layer laminated on one side of the substrate 21. The compound semiconductor thin-film crystal layer has a configuration where a buffer layer 22, a first-conductivity-type semiconductor layer containing a first-conductivity-type cladding layer 24, an active layer structure 25, a second-conductivity-type semiconductor layer containing a second-conductivity-type cladding layer 26 and a contact layer 23 are sequentially laminated from the side of the substrate 21.

On a part of the surface of the contact layer 23 is disposed a second-conductivity-type-side electrode 27 for current injection, and the area where the contact layer 23 is in contact with the second-conductivity-type-side electrode 27 is a second current injection area 35 for injecting current into the second-conductivity-type semiconductor layer. There is disposed a first-conductivity-type-side electrode 28 in the surface opposite to the thin-film crystal layer in the substrate 21, that is, the rear surface.

By disposing the second-conductivity-type-side electrode 27 and the first-conductivity-type-side electrode 28 as described above, these are arranged on the opposite sides to each other sandwiching the substrate 21 and the light-emitting element 10 is configured as a so-called a vertical conduction type light-emitting element 10. The vertical conduction type light-emitting element 10 can get a first-conductivity-type-side electrode and a second-conductivity-type-side electrode from the upper and the lower sides, respectively, so that a part of the laminated semiconductor layer does not have to be removed by, for example, etching for forming a first-conductivity-type-side electrode, allowing the manufacturing process to be simplified.

Furthermore, also this embodiment has an insulating film covering the whole structure described above except a part of the surface of the second-conductivity-type-side electrode 27 and a part of the surface of the first-conductivity-type-side electrode 28 and the sidewall of the second-conductivity-type semiconductor layer is covered with the insulating film as shown in FIG. 21. Current can be injected into the light-emitting element 10 from the part where the second-conductivity-type-side electrode 27 is exposed and the part where the first-conductivity-type-side electrode 28 is exposed because of the absence of an insulating film.

Alternatively, as shown FIG. 22, the element may have a structure where an insulating film is absent in the first-conductivity-type-side electrode 28. Here, current can be injected into the light-emitting element 10 from the part where the second-conductivity-type-side electrode 27 is exposed and the first-conductivity-type-side electrode 28 because of the absence of an insulating film.

The insulating film, as shown in FIGs. 21 and 22, just have to have at least the crystal quality improving layer 30 like the flip-chip type light-emitting element as described above, and preferably further has at least one antireflection layer 31 covering the crystal quality improving layer 30. In this embodiment, the insulating film is formed as a multilayer film having the crystal quality improving layer 30 and a couple of the antireflection layers 31.

Each layer constituting the light-emitting element 10 can be formed as described for the flip-chip type light-emitting element as described above. However, it is necessary in this embodiment that the substrate 21 and the buffer layer 22 are generally of the first-conductivity-type in order to form the first-conductivity-type-side electrode 28 on the rear surface of the substrate; for example, when the first-conductivity-type is n-type, it is preferable that the substrate 21 and the buffer layer 22 are doped by an n-type dopant. In manufacturing the light-emitting element 10, it is desirable to form a p-type cladding layer which is less crystalline after crystal growing of the active layer structure 25, and from this standpoint; it is desirable that the first-conductivity-type is n-type while the second-conductivity-type is p-type.

Manufacturing process

Next, there will be described a process for manufacturing a semiconductor light-emitting element of the present invention with reference to a flip-chip type light-emitting element as an example.

In an example of a manufacturing process of the present invention, first ,a substrate 21 is prepared, and then on its surface are sequentially deposited a buffer layer 22, a first-conductivity-type cladding layer 24, an active layer structure 25 and a second-conductivity-type cladding layer 26 by film crystal growth, as shown in FIG.

3. These thin-film crystal layers are desirably formed by MOCVD. However, another method such as MBE, PLD, PED, PSD, VPE and LPE may be employed for forming all or some of the thin-film crystal layers. The layer configuration can be appropriately changed, depending on, for example, a purpose of the element. After forming the thin-film crystal layer, various processing may be conducted. As used herein, the term, "film crystal growth" includes heating of a thin-film crystal layer after its growth.

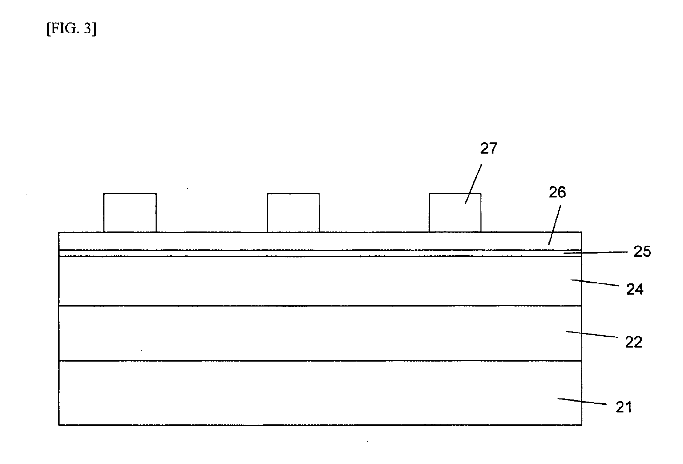

After the growth of the thin-film crystal layer, it is preferable to form a second-conductivity-type-side electrode 27 as shown in FIG. 3. In other words, it is desirable that the second-conductivity-type-side electrode 27 is formed in a predetermined second current injection area 35 before forming an insulating film, before forming a first current injection area 36 and further, before forming a first-conductivity-type-side electrode 28. This is because when as a desirable configuratron, a second conductivity type is p-type, formation of a p-side electrode after various processings of the surface of the exposed p-type cladding layer reduces, due to process damage, a hole concentration in the p-type cladding layer with a less activation rate among GaN materials. Thus, in the present invention it is preferable to conduct, after film crystal growth, formation of the second-conductivity-type-side electrode 27 before other process steps such as the first etching step, the second etching step, the step of forming a part where the second-conductivity-type-side electrode is exposed, the step of forming the first current injection area and the step of forming the first-conductivity-type-side electrode described above).

On the other hand, in the present invention, it is possible that the crystal quality improving layer 30 or optionally the whole insulating film is appropriately formed and in each process, damage occurring in the thin-film crystal layer is removed. Alternatively, when the crystal quality improving layer 30 is, for example, made of $SiN_x$ or $SiO_xN_y$, it is also desirable that once $SiN_x$ or $SiO_xN_y$ formed in the course of manufacturing a light-emitting element is removed by a method such with relatively smaller process damage as wet etching for eliminating damage in the thin-film crystal layer, a subsequent process is conducted.

For example, it is possible and preferable that an etching mask in the first etching step described later is made workable as a crystal quality improving layer, by forming the etching mask while both relatively active nitrogen and hydrogen are supplied. Even in such a case, the etching mask is preferably produced by forming $SiN_x$ or $SiO_xN_y$ as a constituting material. It is preferable that a hydrogen-atom concentration in the crystal quality improving layer which also works as an etching mask is $1 \times 10^{21}$ atoms/cm$^3$ or more and $1 \times 10^{22}$ atoms/cm$^3$ or less for $SiN_x$ and a nitrogen-atom concentration is 30 atomic% or more and 60 atomic% or less. Furthermore, a refractive index in this case is, for $SiN_x$, preferably 1.80 or more and 2.00 or less as a refractive index at a wavelength of 405 nm and 1.75 or more 1.95 or less at a wavelength of 633 nm. For $SiO_xN_y$, a refractive index is preferably 1.45 or more 1.90 or less at a wavelength of 405 nm and also 1.45 or more and 1.90 or less at a wavelength of 633 nm. However, when such a crystal quality improving layer which also works as an etching mask is completely removed in an element after finishing, crystallinity of the thin-film crystal layer cannot be reliably maintained for a long period. Thus, it is most preferable to separately form a further crystal quality improving layer 30 as the first layer of the insulating film.

When it is attempted to conveniently form the antireflection layer 31 while producing the effect of the crystal quality improving layer 30, it is preferable to form the insulating film after completion of all of the step of forming the second-conductivity-type-side electrode 27, the first etching step and the second etching step.

In the present invention, when the layer on which the second-conductivity-type-side electrode 27 is formed is the second-conductivity-type contact layer, process damage to the second-conductivity-type semiconductor layer can be again reduced.

The second-conductivity-type-side electrode 27 can be formed by applying a variety of deposition processes such as sputtering, vacuum deposition and plating, and a desired shape can be obtained by appropriately applying, for example, a lift-off process using photolithography technique or site-selective vapor deposition using, for example, a metal mask.

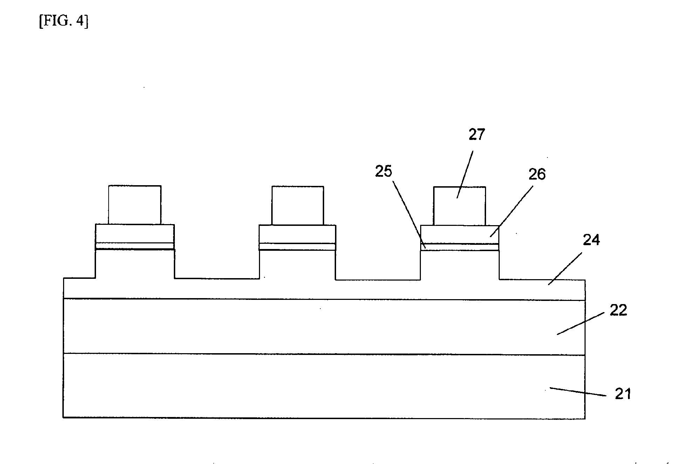

After forming the second conductivity type side electrode 27, a part of the first-conductivity-type cladding layer 24 is exposed as shown in FIG. 4. In this step, it is preferable to remove the second-conductivity-type cladding layer 26, the active layer structure 25 and further a part of the first-conductivity-type cladding layer 24 by etching (a first etching step). The first etching step is conducted for the purpose of exposing a semiconductor layer into which a first-conductivity-type-side electrode described later injects first-conductivity-type carriers, and therefore, when a thin-film crystal layer contains another layer, for example, a cladding layer consists of two layers or contains a contact layer, the layer including the additional layer may be etched.

Since etching does not have to be very precise in the first etching step, well-known etching technique can be employed in accordance with plasma etching using, for example, $Cl_2$ and, as an etching mask, a nitride such as $SiN_x$, an oxide such as $SiO_x$ or an oxynitride such as $SiO_xN_y$. Here, it is possible and preferable that the etching mask can be made workable as a a crystal quality improving layer, by forming the etching mask used in the first etching step while both relatively active nitrogen and hydrogen are supplied. Even in such a case, the etching mask is preferably produced by forming $SiN_x$ or $SiO_xN_y$ as a constituting material. Here, a hydrogen-atom concentration is preferably $1 \times 10^{21}$ atoms/cm$^3$ or more and $1 \times 10^{22}$ atoms/cm$^3$ or less, more preferably $2 \times 10^{21}$ atoms/cm$^3$ or more and $7 \times 10^{21}$ atoms/cm$^3$ or less, most preferably $3 \times 10^{21}$ atoms/cm$^3$ or more and $5 \times 10^{21}$

atoms/cm$^3$ or less for $SiN_x$. A nitrogen-atom concentration is preferably 30 atomic% or more and 60 atomic% or less, more preferably 40 atomic% or more and 50 atomic% or less. Furthermore, in this case, a refractive index is preferably 1.80 or more and 2.00 or less at a wavelength of 405 nm and 1.75 or more 1.95 or less at a wavelength of 633 nm for $SiN_x$. For $SiO_xN_y$, a refractive index is preferably 1.45 or more and 1.90 or less at a wavelength of 405 nm and 1.45 or more and 1.90 or less at a wavelength of 633 nm. However, when such a crystal quality improving layer which also works as an etching mask is completely removed in an element after finishing, crystallinity of the thin-film crystal layer cannot be reliably maintained for a long period. Thus, it is most preferable to separately form a further crystal quality improving layer 30 as the first layer of the insulating film.

On the other hand, it is also desirable that the second etching step is dry etching using a metal fluoride mask. In particular, the etching is preferably conducted by plasma excited dry etching with a gas such as $Cl_2$, $SiCl_4$, $BCl_3$ and $SiCl_4$, using an etching mask including a metal fluoride layer selected from the group consisting of $SrF_2$, $AlF_3$, $MgF_2$, $BaF_2$, $CaF_2$ and combinations of these. Furthermore, dry etching is optimally ICP type dry etching which can generate high-density plasma.

Next, as shown in FIG. 5, an inter-device separating trench 13 is formed by the second etching step. In the present invention, the inter-device separating trench 13 is formed to the middle of the buffer layer 22 in a thickness direction. However, the inter-device separating trench 13 may be formed to reach the substrate 21. Here, for separation between elements, peeling of a GaN material on a sapphire substrate can be prevented during diamond scribing from the side having the thin-film crystal layer in the step of scribing, braking or the like. There is an advantage that when laser scribing is conducted, the thin-film crystal layer is not damaged. Furthermore, it is similarly preferable to form an inter-device separating trench by conducting etching to a part of the sapphire substrate.

The second etching step requires more deep etching of the GaN material, compared to the first etching step. In general, the layer etched by the first etching step amounts to about 0.5 $\mu$m, while it may amount to 3 to 10 $\mu$m because the second etching step requires etching the whole first-conductivity-type cladding layer 24 and the buffer layer 22.

Generally, a metal mask, a nitride mask such as $SiN_x$ or an oxide mask such as $SiO_x$ has a selectivity of 5 to a GaN material resistant to etching with $Cl_2$ plasma, so that for conducting the second etching step where a GaN material with a large film thickness must be etched, a relatively thicker $SiN_x$ film is required. For example, when a 10 $\mu$m GaN material is etched by the second etching step, a $SiN_x$ mask with a thickness of more than 2 $\mu$m is required. However, in a $SiN_x$ mask with about such a thickness, the $SiN_x$ mask is also etched during dry etching, leading to change not only in its thickness in a vertical direction but also a shape in a horizontal direction, so that only a desired part in the GaN material cannot be selectively etched.

Thus, when the inter-device separating trench 13 is formed in the second etching step, it is preferable to conduct dry etching using a mask containing a metal fluoride layer. A material constituting a metal fluoride layer is preferably selected from $MgF_2$, $CaF_2$, $SrF_2$, $BaF_2$ and $AlF_3$ in the light of balance between dry etching resistance and wet-etching properties, and among these, $SrF_2$ is most preferable.

A metal fluoride film must be adequately resistant to dry etching conducted in the first and the second etching steps, while being easily etched by etching for patterning (preferably wet etching), giving a good patterning shape, particularly a shape exhibiting good linearity in the sidewall part. By setting a deposition temperature of the metal fluoride layer at 150 °C or higher, a dense film exhibiting good adhesiveness to an underlying layer and at the same time a mask sidewall with good linearity is provided after patterning by etching. A deposition temperature is preferably 250°C or higher, more preferably 300 °C or higher, most preferably 350 °C or higher. Particularly, a metal fluoride layer deposited at 350 °C or higher exhibits good adhesiveness to any type of underlying layer and is a dense film, which is highly resistant to dry etching while exhibiting good linearity in the sidewall part in terms of a patterning shape and ensuring controllability on the width of an opening, thus being most preferable as an etching mask.

A mask patterned considering these respects, which may be laminated with, for example, $SiN_x$, $SiO_x$ and/or $SiO_xN_y$ such that a metal fluoride layer becomes the surface layer, is used for conducting dry etching. A gas species for dry etching is desirably selected from $Cl_2$, $BCl_3$, $SiCl_4$, $CCl_4$ and combinations of these. Since during dry etching, a selectivity of the $SrF_2$ mask to a GaN material is more than 100, a thick film GaN material can be easily and precisely etched. Furthermore, a dry etching method is optimally ICP type dry etching which can generate high-density plasma.

Such a second etching step can form an inter-device separating trench 13 as shown in FIG. 5.

Here, the first etching step and the second etching step can be conducted in any order.

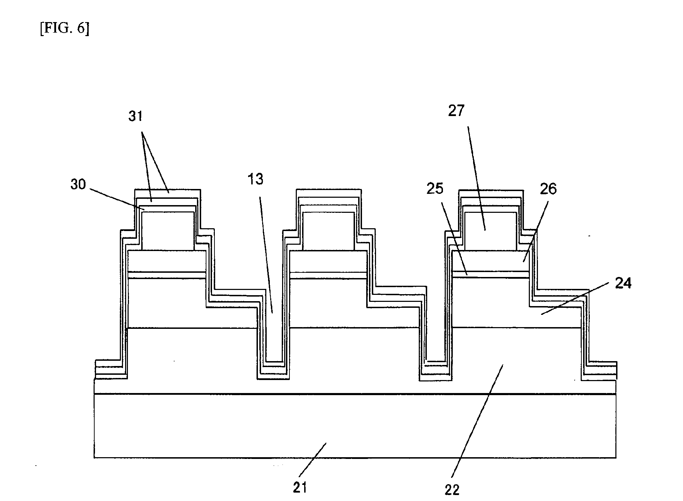

After the second etching step, an insulating film is formed by sequentially depositing the crystal quality improving layer 30 and the antireflection layer 31 as shown in FIG. 6. The materials for the crystal quality improving layer 30 and the antireflection layer 31 can be appropriately selected as described above. In terms of a deposition method, first, the crystal quality improving layer can be formed by any of various deposition methods such as plasma CVD, ion plating, ion assisted deposition and ion-beam sputtering, and preferred is a method in which both relatively active nitrogen and hydrogen can be supplied during forming the crystal quality improving layer. In particular, the crystal quality improving layer 30 is preferably formed by plasma CVD while $NH_3$ is supplied as a source gas. Here, a step coverage varies depending on a deposition method and the deposition conditions, so that in terms of a film thickness of the resulting insulating film, there may be a difference, for example, between a film thickness in a lamination direction of each layer in the thin-film crystal layer and a film thickness on the sidewall of the thin-film crystal layer. Thus, the term, "a film thickness of an insulating film" (including film thicknesses of the crystal quality improving layer 30 and the antireflection layer 31 constituting an insulating film) as used herein, refers to a film thickness of each layer in the thin-film crystal layer in a lamination direction.

In terms of a whole thickness, the insulating film is preferably formed such that it meets the relationship Ta > Tb as described above (see FIG. 2). It is desirable to determine a whole thickness of the insulating film meeting the relationship, considering not only a film thickness of each layer whereby the crystal quality improving layer 30 and the antireflection layer 31 described above become effective, but also an etching depth of the first-conductivity-type cladding layer 24 in the first etching step.

It is preferable to continuously form the antireflection layer 31 using the identical apparatus in formation of the crystal quality improving layer 30. However, since supplying both relatively active nitrogen and hydrogen is not essential in forming the antireflection layer 31, it can be formed under different conditions.

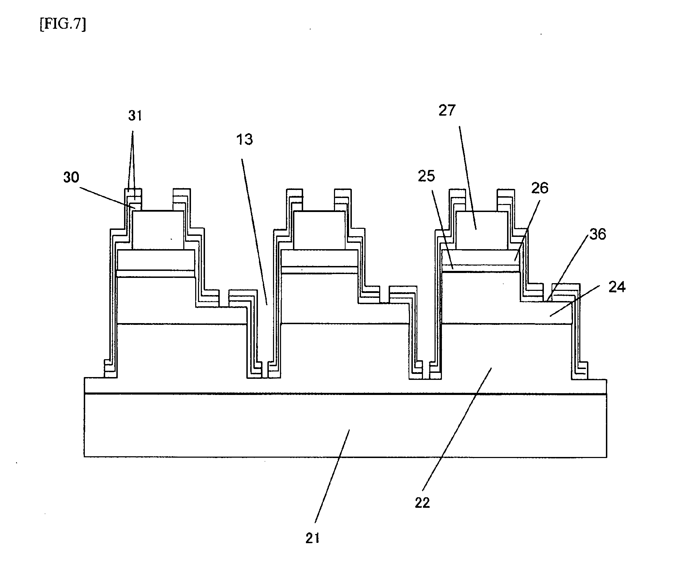

Next; as shown in FIG. 7, a predetermined part in the insulating film as a multilayer film consisting of the crystal quality improving layer 30 and the antireflection layer 31 is removed, to form an exposed part in the second conductivity type side electrode 27 without the insulating film on a part of the second-conductivity-type-side electrode 27, a first current injection area 36 without the insulating film on the first-conductivity-type cladding layer, and a scribe area without the insulating film in the inter-device separating trench 13. The insulating film on the second-conductivity-type-side electrode 27 is removed such that the surrounding part of the second-conductivity-type-side electrode 27 is covered with the insulating film. In other words, a surface area of the exposed part in the second-conductivity-type-side electrode is smaller than the second current injection area.

For removing the predetermined part of the insulating film, an appropriate etching method such as dry etching and wet etching can be selected, depending on the materials chosen.

Here, when wet etching is used for removing the predetermined part in the insulating film, it is preferable to use a material facilitating shape control during wet etching, for the uppermost layer in the antireflection layer 31. For example, when the antireflection layer 31 is constituted by a single layer of $SiO_x$, side etching relatively tends to occur by a wet etchant such as a mixture of hydrofluoric acid and ammonium fluoride. Thus, difficulties are involved in exposing the exposed part in the second-conductivity-type-side electrode 27 with a higher area precision or forming the first current injection area 36 with higher dimensional precision due to a short time margin during conducting the process. In such a case, it is preferable that the antireflection layer 31 consists of two layers of $SiO_x$ and $SiN_x$ from the side of the crystal quality improving layer 30 and the uppermost layer, that is, the layer finally formed, is $SiN_x$, allowing excessive side etching to be prevented. In such a case, it is also preferable that $SiN_x$, the uppermost layer, is so thin that it does not substantially influence reflectance setting of the whole antireflection layer 31.

A material for the antireflection layer 31 is preferably selected from $AlO_x$, $SiO_x$, $TiO_x$, $MgF_2$, $SiN_x$ and $SiO_xN_y$. When the antireflection layer 31 consists of two or more layers, it is preferable that the uppermost layer is so thin that it does not substantially influence reflectance setting of the whole antireflection layer 31 and thus can prevent side etching during wet etching for removing the uppermost layer. When the antireflection layer 31 consists of two or more layers as described above, the uppermost layer can be made of a metal fluoride such as $SrF_2$, a nitride such as $SiN_x$ or the like, particularly preferably $SiN_x$. For example, a theoretically very small reflectance of 0.02 % at a wavelength of 405 nm can be achieved by forming an insulating film with a monolayer crystal quality improving layer 30 made of $SiN_x$ with a thickness of 30 nm and a two-layered antireflection layer 31 formed by depositing $SiN_x$ with to 5 nm on SiOx with a thickness of 38 nm.

The exposed part in the second-conductivity-type-side electrode 27, the first current injection area 36 and the scribe area may be separately formed, but generally they are simultaneously formed by etching.

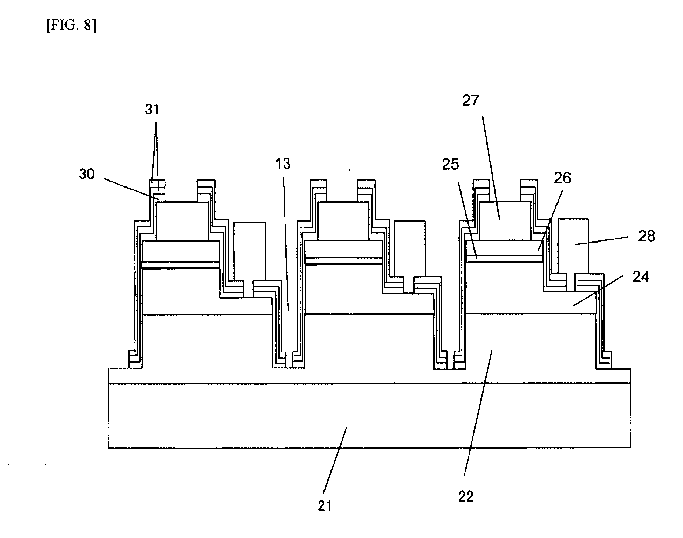

Next, as shown in FIG. 8, a first-conductivity-type-side electrode 28 is formed. In this embodiment, the first-conductivity-type-side electrode 28 is formed such that it has a larger area than the first current injection area, and the first-conductivity-type-side electrode 28 is not spatially overlapped with the second-conductivity-type-side electrode 27. This is important for ensuring an adequate gap to prevent unintentional short circuit due to a solder material between the second-conductivity-type-side electrode 27 and the first-conductivity-type-side electrode 28 while ensuring an adequate area to ensure adequate adhesiveness to, for example, a submount in the process of flip-chip mounting of the light-emitting element with a solder.

As described above, when the first-conductivity-type is n-type, the electrode material desirably contains any or all materials selected from Ti, Al, Ag and Mo as a constituent element. An electrode material can be deposited by applying any of various deposition methods such as sputtering, vacuum deposition and plating, and the electrode can be shaped by appropriately applying a lift-off method using photolithography technique, site-selective vapor deposition using, for example, a metal mask, or the like.

In this embodiment, the first-conductivity-type-side electrode 28 is formed such as it is partly in contact with the first-conductivity-type cladding layer 24 and, when the first-conductivity-type-side contact layer is formed, can be formed such that it is in contact with the contact layer.

The manufacturing process of this embodiment is also advantageous in the light of reduction of process damage, because the first-conductivity-type-side electrode 28 is manufactured in the final step of forming the laminate structure. When the first-conductivity-type is n-type, Al is, in a preferable embodiment, deposited on the surface of the electrode material of the n-side electrode. Here, if the n-side electrode is formed before formation of the insulating film as in the second-conductivity-type-side electrode, the surface of the n-side electrode, that is, Al metal traces the etching process of the insulating film. Etching of the insulating film is conveniently, for example; wet etching using a hydrofluoric acid etchant as described above, but Al is less tolerant to various etchants including hydrofluoric acid, and thus when such a process is effectively conducted, the electrode itself may be damaged. Furthermore, when dry etching is conducted, Al is relatively reactive so that damage including oxidation may be introduced. In the present invention, it is, therefore, effective for reducing damage in an electrode to form the first-conductivity-type-side electrode 28 after forming the insulating film and after scheduled removal of an unwanted part in the insulating film.

After thus forming the structure in FIG. 8, the substrate 21 is scribed with a diamond scribe and a part of the substrate material is ablated by a laser scribe at the site where the inter-device separating trench 13 has been formed, for individually separating the light-emitting elements from each other.

During the step of inter-element separation, in the site where the inter-device separating trench 13 has been formed, process damage is little introduced to the thin-film crystal layer because most of the thin-film crystal layer is removed. Furthermore, since an insulating film is absent in the scribe area, peeling of an insulating film never occurs during scribing.

After completion of scribing, the light-emitting elements are divided into individual devices by the braking step, and then are mounted on a submount preferably through, for example, a solder material.

As described above, the light-emitting element shown in FIG. 1 is produced.

In this manufacturing process, it is desirable to sequentially conduct forming the thin film crystal layer, forming the second-conductivitytype-side electrode 27, etching (the first and the second etching steps), forming the crystal quality improving layer 30, forming the antireflection layer 31, removing the crystal quality improving layer 30 and the antireflection layer 31 (forming the exposed part in the second-conductivity-type-side electrode, forming the first current injection area 36 and forming the scribe area), and forming the first-conductivity-type-side electrode 28, as described above. By this process sequence, the thin-film crystal layer directly below the second-conductivity-type-side electrode 27 is not damaged and damage in a crystal growth layer unintentionally introduced during each process can be remedied by a crystal quality improving layer, so that a high-quality light-emitting element 10 can be obtained.

EXAMPLES

There will be more specifically described the features of the present invention with reference to Examples. Factors such as the materials, their amounts, their proportions, details in the processes and the process procedures described in Examples below may be appropriately modified without departing from the concept of the present invention. The scope of the present invention should not be, therefore, interpreted by the specific examples described below in any limited way. In the drawings referred in the following examples, some dimensions are intentionally changed to make the structure easy to understand, but actual dimensions are as described in the following description.

Example 1

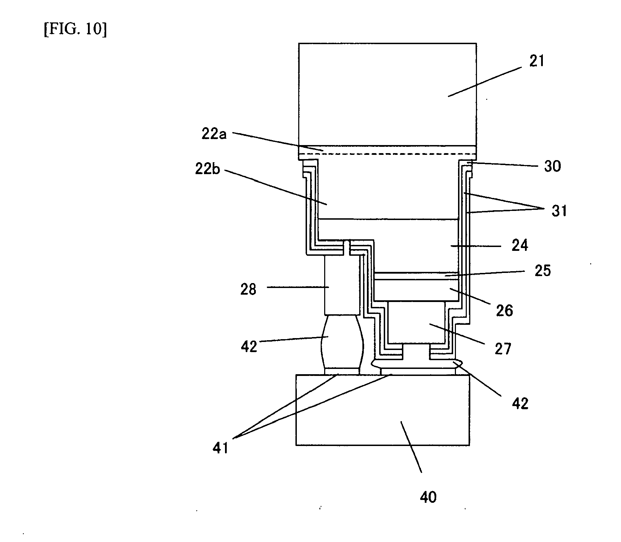

A light-emitting element shown in FIG. 10 was prepared by the procedure described below. See FIGs. 3 to 8 as relevant process drawings.

There was prepared a c+ plane sapphire substrate 21 with thickness of 430 $\mu$m, on which were formed undoped GaN grown at a low temperature to a thickness of 10 nm as a first buffer layer 22a using MOCVD and then undoped GaN as a second buffer layer 22b to a thickness of 4.0 $\mu$m at 1040 °C.

Furthermore, an Si doped (Si concentration: $5 \times 10^{18}$ cm$^{-3}$) GaN layer was formed to a thickness of 4.5 $\mu$m as the first-conductivity-type (n-type) cladding layer 24. Furthermore, as the active layer structure 25, were alternately deposited undoped GaN layers to 13 nm as a barrier layer at 860 °C and undoped In$_{0.06}$Ga$_{0.94}$N layers as a quantum well layer to 2 nm at 720 °C, such that 8 quantum well layers in total were formed and both sides were barrier layers. Then, was formed Mg doped (Mg concentration: $5 \times 10^{19}$ cm$^{-3}$) Al$_{0.2}$Ga$_{0.8}$N as the second-conductivity-type (p-type) cladding layer 26 to 0.02 $\mu$m at a growth temperature of 1000 °C, and subsequently, was formed Mg doped (Mg concentration: $5 \times 10^{19}$ cm$^{-3}$) GaN to 0.1 $\mu$m.

Next, the wafer was gradually cooled in the MOCVD growth furnace and then was removed to terminate film crystal growth.

Then, for forming the p-side electrode 27, the wafer after film crystal growth was processed by photolithography to prepare for patterning the p-side electrode 27 by a liftoff process and then a resist pattern was formed. Here, as the p-side electrode 27 was formed Ni 20 nm/Au 500 nm by vacuum deposition and the unwanted part was removed by a liftoff process in acetone. Next, the wafer was heated to complete the p-side electrode 27. The structure so far substantially corresponds to FIG. 3.

Next, for conducting the first etching step, a mask for etching was formed. Here, by plasma CVD, $SiN_x$ was deposited over the whole surface of the wafer to a thickness of 0.4 $\mu$m. The $SiN_x$ deposition conditions were a pressure of 200 Pa and an RF power of 250 W under substrate heating temperature: 250 °C, $SiH_4$ flow rate: 9 sccm, $NH_3$ flow rate: 13 sccm and $N_2$ flow rate: 225 sccm. Then, photolithography was again conducted to pattern the $SiN_x$ mask, providing a $SiN_x$ etching mask. Here, an unwanted part in the $SiN_x$ film was etched by RIE using $SF_6$ plasma, and the mask was left in the part where the thin-film crystal layer was not etched in the first etching step described later, while the $SiN_x$ film in the part corresponding to the part to be etched in the thin-film crystal layer was removed. The conditions of etching by RIE were as follows; $SF_6$ flow rate: 90 sccm, pressure: 20 Pa and RF power: 235 W.

Subsequently, as the first etching step, ICP etching was conducted using $Cl_2$ gas through the second-conductivity-type (p-type) cladding layer 26, the active layer structure 25 consisting of the InGaN quantum well layers and the GaN barrier layers to the middle of the first-conductivity-type (n-type) cladding layer 24.

Then, for conducting the second etching step for forming the inter-device separating trench 13, an $SrF_2$ mask was formed over the whole surface of the wafer by vacuum deposition. Next, the $SrF_2$ film in the region where the inter-device separating trench 13 was to be formed was removed, to a mask for forming an inter-device separating trench in the thin-film crystal layer, that is, an $SrF_2$ mask for the second etching step.

Next, as the second etching step, the thin-film crystal layer in the part corresponding to the inter-device separating trench 13 was etched by ICP using $Cl_2$ gas through all of the second-conductivity-type (p-type) cladding layer 26, the active layer structure 25 consisting of the InGaN quantum well layers and the GaN barrier layers and the first-conductivity-type (n-type) cladding layer 24 to the middle of the undoped GaN buffer layer 22. During the second etching step, the $SrF_2$ mask was little etched. The inter-device separating trench 13 could be formed with a width equal to that of the mask.

After forming the inter-device separating trench 13 by the second etching step, the $SrF_2$ mask which became unnecessary was removed. Subsequently, the $SiN_x$ mask was completely removed using buffered hydrofluoric acid. Again, the surface of the p-side electrode was not altered at all because Au was exposed on the surface. The structure so far substantially corresponds to FIG. 5.

Then, the crystal quality improving layer 30 made of $SiN_x$ was formed by plasma CVD to a film thickness of 30 nm. Here, a substrate heating temperature was 400 °C. The $SiN_x$ deposition conditions were a pressure of 45 Pa and an RF power of 300 W under $SiH_4$ flow

rate: 5 sccm, $NH_3$ flow rate: 13 sccm and $N_2$ flow rate: 225 sccm.

Then, after forming the crystal quality improving layer 30, over the whole surface of the wafer were formed $SiO_x$ to 38 nm and then $SiN_x$ to 5 nm by plasma CVD as the antireflection layer 31, for adjusting a reflectance of a light vertically entering the insulating film from the thin-film crystal layer side to 0.02 %. The structure so far substantially corresponds to FIG. 6.

The $SiO_x$ deposition conditions were a pressure of 200 Pa and an RF power of 300 W under substrate heating temperature: 400 °C, $SiH_4$ flow rate: 9 sccm and $N_2O$ flow rate: 180 sccm. The conditions of depositing $SiN_x$ as the uppermost layer of the insulating film were a pressure of 45 Pa and an RF power of 300 W under substrate heating temperature: 400 °C, $SiH_4$ flow rate: 5 sccm, $NH_3$ flow rate: 13 sccm and $N_2$ flow rate: 225 sccm.

Here, a wafer was prepared by film crystal growth as described in this example and on the wafer was formed an $SiN_x$ film to thickness of 80 nm by plasma CVD under the conditions as described for forming the crystal quality improving layer (the uppermost layer of the insulating film) to prepare a sample for a preliminary experiment of refractive index measurement, which had a refractive index of 1.92 at a wavelength of 405 nm as determined using a spectroscopic ellipsometer. Likewise, an $SiO_x$ film was formed to a thickness of 100 nm by plasma CVD under the conditions as described for forming the first layer of he antireflection layer to prepare a sample for a preliminary experiment of refractive index measurement, which had a refractive index of 1.45 at a wavelength of 405 nm as determined using a spectroscopic ellipsometer.

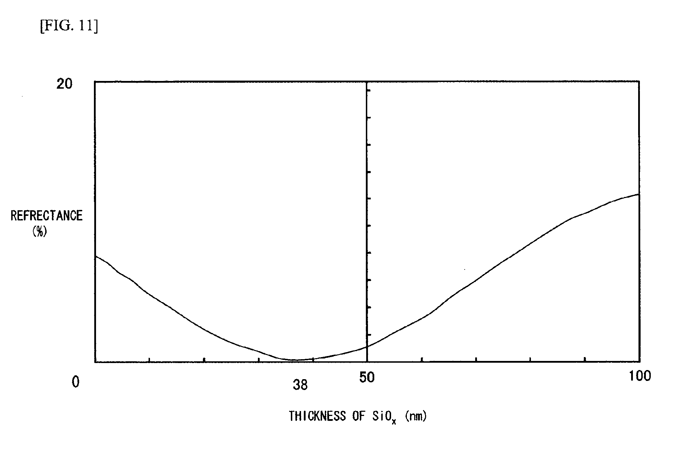

FIG. 11 is a graph showing relationship between an insulating-film reflectance at a wavelength of 405 nm and an $SiO_x$ film thickness when on GaN is deposited a crystal quality improving layer made of $SiN_x$ to a film thickness of 30 nm, on which is further deposited an antireflection layer made of $SiO_x$ and $SiN_x$ to form an insulating film and $SiN_x$ as the uppermost layer in the insulating film has a film thickness of 5 nm. The refractive indices at a wavelength of 405 nm for $SiN_x$ and $SiO_x$ used in this calculation were 1.92 and 1.45, respectively, from the above preliminary experiments for refractive index determination. As seen from this graph, an insulating-film reflectance is smallest, 0.02 %, when the $SiO_x$ antireflection layer has a film thickness of 38 nm.

Then, for simultaneously forming a p-side electrode exposing part on the p-side electrode 27 made of Ni-Au, an n-side current injection area on the first-conductivity-type (n-type) cladding layer 24 and a scribe area within the inter-device separating trench, photolithography was employed for removing a part of the crystal quality improving layer 30 and antireflection layer 31 to form a resist mask. Then, the crystal quality improving layer 30 and the antireflection layer 31 in the part which was not covered with the resist mask was removed with a hydrofluoric-acid containing etchant. Here, a side-etching amount after wet etching was reduced to 1/3 in comparison the case without the uppermost SiN$_x$ layer in the insulating film.

Subsequently, the resist mask which became unnecessary was removed with acetone. An insulating film was thus formed and the structure so far substantially corresponds to FIG. 7.

Next, for forming the n-side electrode 28, a resist pattern was formed by photolithography as preparation of patterning the n-side electrode by a liftoff process. Here, over the whole surface of the wafer was formed Ti (20 nm)/Al (300 nm) as the n-side electrode 28 by vacuum deposition and the unwanted part was removed in acetone by a liftoff process. Then, the n-side electrode 28 was produced by subsequent heat process. The n-side electrode 28 was formed such that it has a larger area than the n-side current injection area and does not overlap the p-side electrode 27, also considering easiness in flip-chip bonding with a metal solder, heat dissipation ability and so on. Although an Al electrode tends to be altered by, for example, a plasma process and is susceptible to etching by, for example, hydrofluoric acid, it was not damaged at al because the n-side electrode 28 was formed in the last step of the element producing process. The structure so far substantially corresponds to FIG. 8.

Then, for separating the individual light-emitting elements formed on the wafer, a scribe line was formed within the inter-device separating trench 13 from the film crystal growth side using a laser scriber. Furthermore, along the scribe line, the sapphire substrate 21 was broken to provide individual light-emitting elements. Here, damage was not introduced in the thin-film crystal layer.

Subsequently, this element was joined with a metal layer 41 in a submount 40 using a metal solder 42, to provide the light-emitting element shown in FIG. 10. Here, no defects including unintentional short circuit occurred in the element. Then, the element was mounted in a metal package to provide the light-emitting element.

The light-emitting element thus produced exhibited the following initial properties; a total radiation flux at 350 mA current injection: 185 mW and an emission wavelength (center wavelength) peak: 401 nm.

Next, this light-emitting element was sealed with a phosphor paste containing a blue, a green and a red phosphors, to provide a luminescence source emitting white light.

The phosphor paste is a sealing liquid containing a phosphor. The sealing liquid was prepared by first stirring 385 g of dual-silanol-end dimethylsilicone oil (Momentive Performance Materials Japan Inc. (former company name: GE Toshiba Silicone), XC96-723), 10.28 g of methyltrimethoxysilane and 0.791 g of zirconium tetraacetylacetonate powder as a catalyst at room temperature for 15 min and stirring the mixture under total reflux at 100 °C for 30 min for initial hydrolysis. Subsequently, while nitrogen was bubbled into the liquid, the mixture was stirred at 100 °C for one hour and after warming to 130 °C, the polymerization reaction was continued for additional 5.5 hours to prepare a reaction liquid with a viscosity of 389 mPa·s. The reaction liquid thus prepared was cooled to room temperature and kept under vacuum heating conditions (120 °C, 1 kPa) for 20 min to prepare the sealing liquid with a viscosity of 584 mPa·s.

Then, 1 g of the sealing liquid prepared, 0.12 g of hydrophobic fumed silica (Nippn Aerosil Co., Ltd., RX200), 0.0115 g of a red phosphor ((Sr,Ca)AlSiN$_3$:Eu), 0.0221 g of a green phosphor ((Ba,Sr)$_2$SiO$_4$:Eu) and 0.1891 g of a blue phosphor (BaMgAl$_{10}$O$_{17}$:Eu) were blended with defoaming, to prepare the phosphor paste.

The light-emitting element was sealed with the phosphor paste by adding dropwise 40 μL of the phosphor paste to the above light-emitting element using a pipette and keeping the mixture at a high temperature of 90 °C to 150 °C for 6 hours for curing the sealing liquid.

In terms of the luminescence source thus obtained, current of 350 mA was injected to the light-emitting element under the circumstances of a temperature of 85 °C and a humidity of 85 % for conducting high-temperature high-humidity life test. Consequently, a luminous flux of white light after 1000 hours was reduced only by 8 % compared to a luminous flux immediately after the test was started, demonstrating stable operation.

Example 2

A light-emitting element was manufactured as described in Example 1, except that an insulating film was formed such that a crystal quality improving layer made of SiN$_x$ had a film thickness of 30 nm and an antireflection layer made of SiO$_x$ had a film thickness of 50 nm for adjusting a reflectance of a light vertically entering the insulating film from the thin-film crystal layer side to 0.02 % and SiN$_x$ was not formed as the uppermost layer of the insulating film.

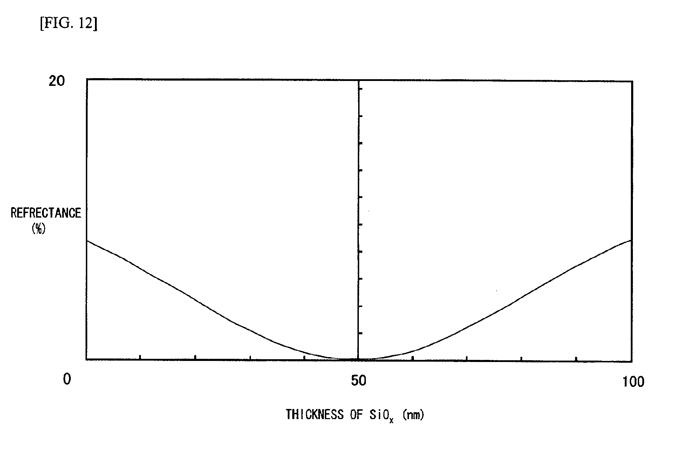

FIG. 12 is a graph showing relationship between an insulating-film reflectance at a wavelength of 405 nm and a film thickness of an antireflection layer (SiO$_x$) when on GaN is deposited a crystal quality improving layer made of SiN$_x$ to a film thickness of 30 nm, on which is further deposited an antireflection layer made of SiO$_x$ to form an insulating film. The refractive indices at a wavelength of 405 nm for SiN$_x$ and SiO$_x$ used in this calculation were 1.92 and 1.45, respectively, from the preliminary experiments for refractive index determination in Example 1. As seen from this graph, an insulating-film reflectance is smallest, 0.02 %, when the antireflection layer has a film thickness of 50 nm.

The light-emitting element thus produced exhibited the following initial properties; a total radiation flux at 350 mA current injection: 184 mW and an emission wavelength (center wavelength) peak: 400 nm.

Using the light-emitting element thus produced, a luminescence source emitting white light was prepared as described in Example 1. For the luminescence source obtained, a high-temperature high-humidity life test was conducted under the conditions as described in Example 1. Consequently, a luminous flux of white light after 1000 hours was reduced only by 8 % compared to a luminous flux immediately after the test was started, demonstrating stable operation.

Example 3

A light-emitting element was manufactured as described in Example 1, except that an insulating film was formed such that a crystal quality improving layer made of $SiN_x$ had a film thickness of 10 nm and an antireflection layer made of $SiO_x$ had a film thickness of 62 nm for adjusting a reflectance of a light vertically entering the insulating film from the thin-film crystal layer side to 0.6 % and $SiN_x$ was not formed as the uppermost layer of the insulating film.

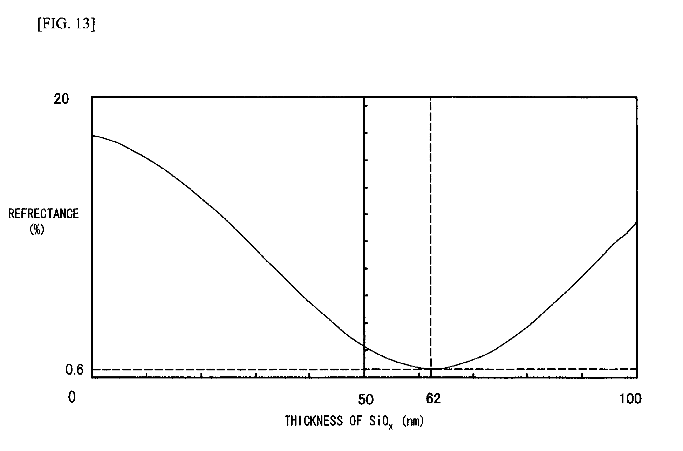

FIG. 13 is a graph showing relationship between an insulating-film reflectance at a wavelength of 405 nm and a film thickness of an antireflection layer ($SiO_x$) when on GaN is deposited a crystal quality improving layer made of $SiN_x$ to a film thickness of 10 nm, on which is further deposited an antireflection layer made of $SiO_x$ to form an insulating film. The refractive indices at a wavelength of 405 nm for $SiN_x$ and $SiO_x$ used in this calculation were 1.92 and 1.45, respectively, from the preliminary experiments for refractive index determination in Example 1. As seen from this graph, an insulating-film reflectance is smallest, 0.6 %, when the antireflection layer has a film thickness of 62 nm.

The light-emitting element thus produced exhibited the following initial properties; a total radiation flux at 350 mA current injection: 184 mW and an emission wavelength (center wavelength) peak: 400 nm.

Using the light-emitting element thus produced, a luminescence source emitting white light was prepared as described in Example 1. For the luminescence source obtained, a high-temperature high-humidity life test was conducted under the conditions as described in Example 1. Consequently, a luminous flux of white light after 1000 hours was reduced only by 9 % compared to a luminous flux immediately after the test was started, demonstrating stable operation.

Example 4

A light-emitting element was prepared as described in Example 1, except that an insulating film was formed such that a crystal quality improving layer made of $SiN_x$ had a film thickness of 50 nm and an antireflection layer made of $MgF_2$ formed by electron beam deposition had a film thickness of 53 nm for adjusting a reflectance of a light vertically entering the insulating film from the thin-film crystal layer side to 1.9 %, $SiN_x$ was not formed as the uppermost layer of the insulating film and ion milling with Ar gas was used for removing a predetermined part of $MgF_2$. The $MgF_2$ deposition conditions were as follows; substrate heating temperature: 300 °C, acceleration voltage: 6 kV and vacuum at the initiation of deposition: $5.5 \times 10^{-4}$ Pa.

Here, a wafer was prepared by film crystal growth as described in Example 1 and on the wafer was formed an $MgF_2$ film to 110 nm by electron beam deposition under the conditions as described for forming the antireflection layer of this example to prepare a sample for a preliminary experiment of refractive index measurement, which had a refractive index of 1.39 at a wavelength of 405 nm as determined using a spectroscopic ellipsometer.

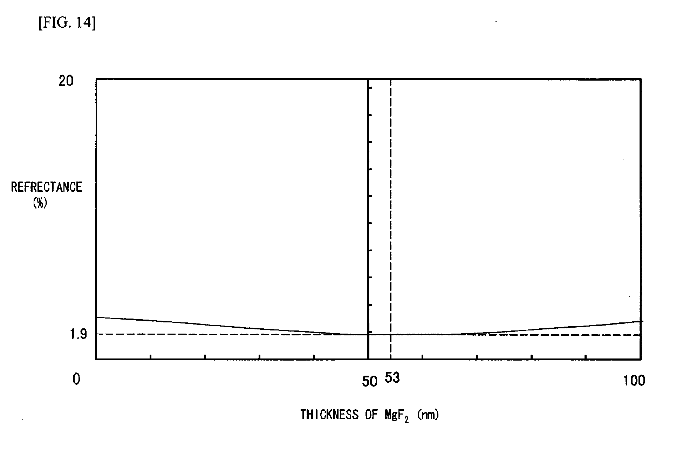

FIG. 14 is a graph showing relationship between an insulating-film reflectance at a wavelength of 405 nm and a film thickness of an antireflection layer ($MgF_2$) when on GaN is deposited a crystal quality improving layer made of $SiN_x$ to a film thickness of 50 nm, on which is further deposited an antireflection layer made of $MgF_2$ to form an insulating film. The refractive indices at a wavelength of 405 nm for $SiN_x$ and $MgF_2$ used in this calculation were 1.92 and 1.39, respectively, from the preliminary experiments for refractive index determination in Example 1 and this example. As seen from this graph, an insulating-film reflectance is smallest, 1.9 %, when the antireflection layer has a film thickness of 53 nm.

The light-emitting element thus produced exhibited the following initial properties; a total radiation flux at 350 mA current injection: 181 mW and an emission wavelength (center wavelength) peak: 401 nm.

Using the light-emitting element thus produced, a luminescence source emitting white light was prepared as described in Example 1. For the luminescence source obtained, a high-temperature high-humidity life test was conducted under the conditions as described in Example 1. Consequently, a luminous flux of white light after 1000 hours was reduced only by 11 % compared to a luminous flux immediately after the test was started, demonstrating stable operation.

Example 5

A light-emitting element was prepared as described in Example 1, except that an insulating film was formed such that a crystal quality improving layer made of $SiN_x$ had a film thickness of 10 nm and an antireflection layer had a two-layer structure consisting of a $TiO_2$ layer with a film thickness of 42.6 nm by electron beam deposition and a $SiO_x$ layer with a film thickness of 77 nm by electron beam deposition for adjusting a reflectance of a light vertically entering the insulating film from the thin-film crystal layer side to 0.5 % and $SiN_x$ was not formed as the uppermost layer of the insulating film.

The conditions of $TiO_2$ deposition were substrate heating temperature: 250 °C and acceleration voltage: 6 kV, and $O_2$ was introduced such that a vacuum at the initiation of deposition was $1.5 \times 10^{-2}$ Pa. The conditions of depositing $TiO_x$ subsequently deposited

were substrate heating temperature: 250 °C and acceleration voltage: 6 kV, and $O_2$ was introduced such that a vacuum at the initiation of deposition was $2.0 \times 10^{-2}$ Pa.

Here, a wafer was prepared by film crystal growth as described in Example 1 and on the wafer was formed an $TiO_2$ film to 70 nm by electron beam deposition under the conditions as described for forming the first layer in the antireflection layer of this example to prepare a sample for a preliminary experiment of refractive index measurement, which had a refractive index of 2.38 at a wavelength of 405 nm as determined using a spectroscopic ellipsometer. Likewise, on the wafer was formed an $SiO_2$ film to 100 nm by electron beam deposition under the conditions as described for forming the second layer in the antireflection layer to prepare a sample for a preliminary experiment of refractive index measurement, which had a refractive index of 1.47 at a wavelength of 405 nm as determined using a spectroscopic ellipsometer.

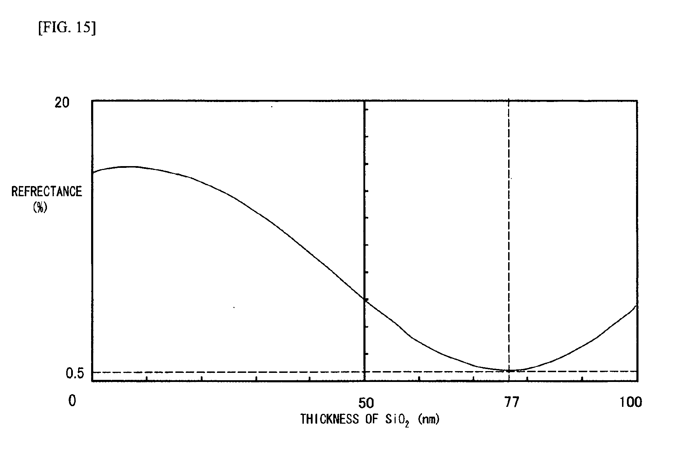

FIG. 15 is a graph showing relationship between an insulating-film reflectance at a wavelength of 405 nm and a film thickness of $SiO_x$ when on GaN is deposited a crystal quality improving layer made of $SiN_x$ to a film thickness of 10 nm, on which is further deposited an antireflection layer having a two-layer structure of $TiO_2$ (film thickness: 42.6 nm) and $SiO_x$ to form an insulating film. The refractive indices at a wavelength of 405 nm for $SiN_x$, $TiO_2$ and $SiO_x$ used in this calculation were 1.92, 2.38 and 1.47, respectively, from the preliminary experiments for refractive index determination in Example 1 and this example. As seen from this graph, an insulating-film reflectance is smallest, 0.5 %, when $SiO_x$ has a film thickness of 77 nm.

The light-emitting element thus produced exhibited the following initial properties; a total radiation flux at 350 mA current injection: 182 mW and an emission wavelength (center wavelength) peak: 402 nm.

Using the light-emitting element thus produced, a luminescence source emitting white light was prepared as described in Example 1. For the luminescence source obtained, a high-temperature high-humidity life test was conducted under the conditions as described in Example 1. Consequently, a luminous flux of white light after 1000 hours was reduced only by 10 % compared to a luminous flux immediately after the test was started, demonstrating stable operation.

Example 6

A light-emitting element was manufactured as described in Example 1, except the steps of film crystal growth and of forming an insulating film were conducted according to the following (1) to (2).

(1) In growing a thin-film crystal layer, a quantum well layer in the active layer structure 25 was an undoped $In_{0.1}Ga_{0.9}N$ layer.
(2) For adjusting a reflectance of a light entering from the side of the thin-film crystal layer to the insulating film to 0.02 %, the insulating film consisted of a crystal quality improving layer made of $SiN_x$ with a film thickness of 25 nm and an antireflection layer made of $SiO_x$ with a film thickness of 62 nm without forming $SiN_x$ as the uppermost layer of the insulating film.

Here, a refractive-index determining preliminary experiment was separately conducted as described in Example 1 and refractive indices at a wavelength of 460 nm as determined by a spectroscopic ellipsometer were 1.91 for $SiN_x$ and 1.44 for $SiO_x$.

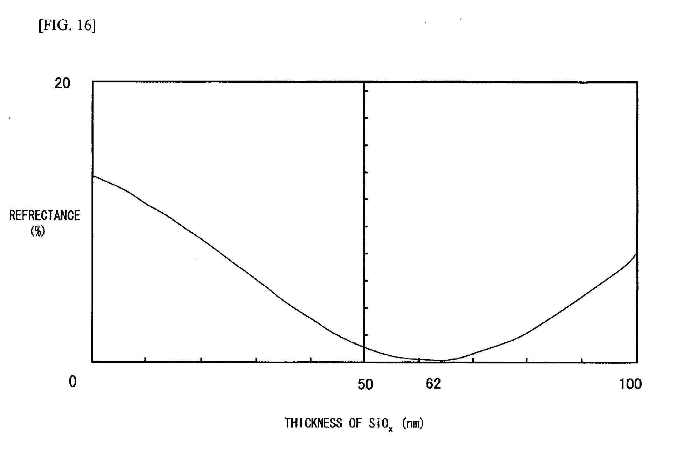

FIG. 16 is a graph showing relationship between an insulating-film reflectance at a wavelength of 460 nm and a film thickness of an antireflection layer ($SiO_x$) when on GaN is deposited a crystal quality improving layer made of $SiN_x$ to a film thickness of 25 nm, on which is further deposited an antireflection layer made of $SiO_x$ to form an insulating film. The refractive indices at a wavelength of 460 nm for $SiN_x$ and $SiO_x$ used in this calculation were 1.91 and 1.44, respectively, from the preliminary experiments for refractive index determination in this example. As seen from this graph, an insulating-film reflectance is smallest, 0.02 %, when the antireflection layer has a film thickness of 62 nm.

The light-emitting element thus produced exhibited the following initial properties; a total radiation flux at 350 mA current injection: 251 mW and an emission wavelength (center wavelength) peak: 459 nm.

Using the light-emitting element thus produced, a luminescence source emitting white light was prepared as described below.

First, 140 g of dual-silanol-end dimethylsilicone oil (GE Toshiba Silicone, XC96-723), 14 g of phenyltrimethoxysilane and 0.308 g of zirconium tetraacetylacetonate powder as a catalyst were stirred at room temperature for 15 min and then stirred under total reflux at 120 °C for 30 min for initial hydrolysis. Subsequently, while nitrogen was bubbled into the liquid, the mixture was stirred for additional 6 hours. The reaction liquid thus prepared was cooled to room temperature and kept under vacuum heating conditions (120 °C, 1 kPa) for 20 min to prepare a sealing liquid.

Then, 1 g of the sealing liquid prepared, 0.07 g of hydrophobic fumed silica (Nippn Aerosil Co., Ltd., RX200), 0.0079 g of a red phosphor ($CaAlSiN_3$:Eu) and 0.0721 g of a green phosphor ($Ca_3(Sc,Mg)_2Si_3O_{12}$:Ce) were blended with defoaming, to prepare a phosphor paste.

Next, 40 μL of the phosphor paste thus prepared was added dropwise to the above light-emitting element using a pipette and the mixture was cured under the conditions as described in Example 1 to produce a luminescence source.

The luminescence source thus produced was evaluated by a high-temperature high-humidity life test under the conditions as described in Example 1. Consequently, a luminous flux of white light after 1000 hours was reduced only by 1 % compared to a luminous flux immediately after the test was started, demonstrating stable operation.

Example 7

In Example 7, a light-emitting element was prepared as described in Example 1, except that a mask for etching in the first etching step was made of $SiO_x$ by plasma CVD and a predetermined part of $SiO_x$ was etched using buffered hydrofluoric acid. Here, the conditions of depositing SiOx as an etching mask were a pressure of 200 Pa and an RF power of 300 W under substrate heating temperature: 400 °C, $SiH_4$ flow rate: 9 sccm and $N_2O$ flow rate: 180 sccm.

The light-emitting element thus produced exhibited the following initial properties; a total radiation flux at 350 mA current injection: 183 mW and an emission wavelength (center wavelength) peak: 402 nm.

Using the light-emitting element thus produced, a luminescence source emitting white light was prepared as described in Example 1. For the luminescence source obtained, a high temperature high-humidity life test was conducted under the conditions as described in Example 1. Consequently, a luminous flux of white light after 1000 hours was reduced only by 9 % compared to a luminous flux immediately after the test was started, demonstrating stable operation.

Example 8

In Example 8, effectiveness of a thin-film crystal layer in improving crystal quality was determined in some steps assuming the process for manufacturing a light-emitting element according to Example 1.

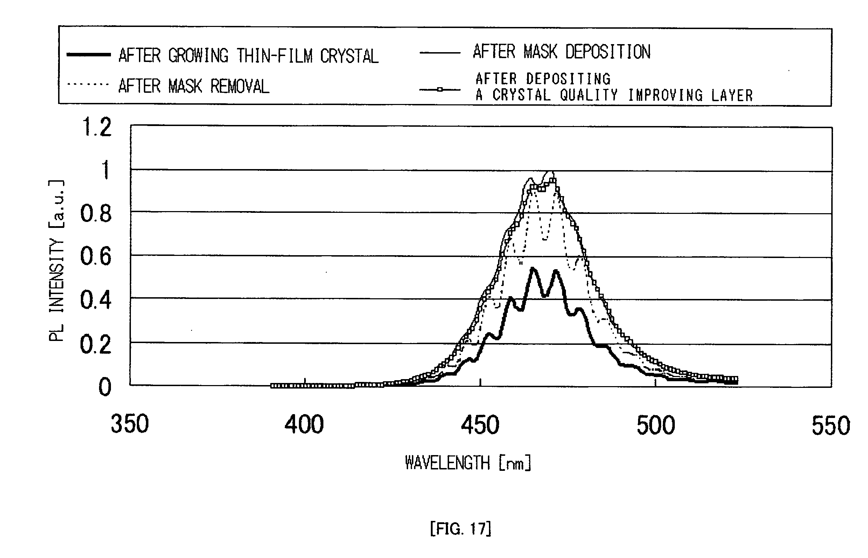

First, a film crystal grown wafer was prepared as described in Example 1, except an emission wavelength (center wavelength) peak was changed to 465 nm, and at this step, a PL intensity was determined for evaluating quality of the thin-film crystal layer obtained. Here, an excitation wavelength of the light used was 325 nm and an excitation density was 0.7 mW/cm². FIG. 17 shows a PL intensity at a typical position in this step (the step of film crystal growth) as a bold solid line. Here, an integral PL intensity was measured including an interference peak in an interface between a sapphire substrate and the thin-film crystal layer.

Then, on the thin-film crystal layer was deposited an $SiN_x$ film to a thickness of 0.4 $\mu$m by plasma CVD. This corresponds to deposition of $SiN_x$ to be an etching mask for the first etching step in Example 1 over the whole surface of the wafer. The conditions were as described for deposition of $SiN_x$ to be an etching mask for the first etching step in Example 1.

PL measurement after depositing the $SiN_x$ film indicated that an average integral PL intensity in the wafer plane was significantly increased to 1.95 times as much as the step of film crystal growth. A PL intensity in a typical position at this step (the step of mask deposition) is indicated by a narrow solid line in FIG. 17. Thus, it is demonstrated that the thin-film crystal layer is effective in improving crystal quality by depositing an $SiN_x$ film to be an etching mask for the first etching step.

Furthermore, at this step, a hydrogen-atom concentration in the $SiN_x$ film was measured by SIMS (Secondary Ion Mass Spectroscopy). The measurement was conducted using a Q-pole type SIMS. Furthermore, a hydrogen-atom concentration was quantified by measuring it for a standard sample at the same time. Consequently, the hydrogen-atom concentration was $3.5 \times 10^{21}$ atoms/cm³.

A nitrogen-atom concentration in the $SiN_x$ film was measured by XPS (X-ray Photoelectron Spectroscopy). For the measurement, MgK$\alpha$ ray was used as excited X-ray. Furthermore, photoelectrons were detected with extraction angle of 45 °. As the result of the measurement, a nitrogen-atom concentration was 46 atomic%.

Furthermore, as determined by a spectroscopic ellipsometer, a refractive index of the $SiN_x$ film was 1.92 at a wavelength of 405 nm and 1.88 at a wavelength of 633 nm.

Next, a resist pattern was formed on the $SiN_x$ film by photolithography. Then, an exposed part in the $SiN_x$ film was removed using $SF_6$ plasma by RIE. The etching conditions in RIE were as follows; $SF_6$ flow rate: 90 sccm, pressure: 20 Pa and RF power: 235 W.

Then, the resist pattern was completely removed by acetone. This corresponds to preparation of an $SiN_x$ etching mask by patterning an $SiN_x$ mask in Example 1.

At this step (the step of mask removal), a PL intensity was measured at one point in the removed part in the $SiN_x$ film, and as a result, it was 1.54 times as much as that in a PL intensity at the substantially same point in the step of film crystal growth, indicating the effect of improving a PL intensity, but the intensity was reduced in comparison with the PL intensity in the step of mask deposition, indicating a reduced degree of the improvement effect. A PL intensity at a typical position at this point is indicated by a broken line in FIG. 17.

Then, the remaining $SiN_x$ film was completely removed with buffered hydrofluoric acid, and again, an $SiN_x$ film was deposited to a film thickness of 30 nm by plasma CVD over the whole surface of the wafer. This corresponds to deposition of a crystal quality improving layer as the first layer over the whole surface in Example 1. The conditions of $SiN_x$ film deposition were as described for the deposition of the crystal quality improving layer in Example 1.

Here, a PL intensity was measured at the substantially same point as PL intensity measurement after removal of the $SiN_x$ film in the step of mask removal, and it was 1.90 times as much as that in a PL intensity at the substantially same point in the step of film crystal growth. This step again demonstrated the effect of deposition of

the $SiN_x$ film as a crystal quality improving layer. A PL intensity at a typical position at this step (the step of crystal quality improving layer deposition) is indicated as a curve formed by connecting data points represented by squares in FIG. 17.

Subsequently, under the conditions as described in Example 1, over the whole surface of the wafer were formed $SiO_x$ corresponding to an antireflection layer to a film thickness of 38 nm and then $SiN_x$ to a film thickness of 5 nm by plasma CVD. At this step, again, the effect as a crystal quality improving layer was maintained.

Example 9

In Example 9, the process until formation of an antireflection layer was conducted under the conditions as described in Example 7, and in some steps in the course of the process, a PL intensity was measured as described in Example 8. From the measurement results, a relative PL-intensity ratio of the step of mask deposition to the step of film crystal growth was 1.14, which did not demonstrate significant improvement in a PL intensity. In the step of mask removal, the ratio was 0.93, indicating reduction in a PL intensity. The ratio was 1.85 in the step of crystal quality improving layer deposition, demonstrating that the $SiN_x$ film is effective in improving crystal quality. This effect of improving crystal quality was also maintained in the step of antireflection layer deposition.

Example 10

There was prepared a c+ plane sapphire substrate 21 with a thickness of 430 $\mu$m, on which were formed undoped GaN grown at a low temperature to a thickness of 20 nm as a first buffer layer 22a using MOCVD and then undoped GaN as a second buffer layer 22b to a thickness of 1.0 $\mu$m at 1070 °C.

Furthermore, an Si doped (Si concentration: 5 $\times$ $10^{18}$ cm$^{-3}$) GaN layer was formed to a thickness of 3.0 $\mu$m as the first-conductivity-type (n-type) cladding layer 24. Furthermore, as the active layer structure 25, undoped GaN layers to 12 nm as a barrier layer at 775 °C and undoped $In_{0.07}Ga_{0.93}N$ layers as a quantum well layer to 1.2 nm at 775 °C were alternately deposited, such that 5 quantum well layers in total were formed and both sides were barrier layers. Then, was formed Mg doped (Mg concentration: 5 $\times$ $10^{19}$ cm$^{-3}$) $Al_{0.1}Ga_{0.9}N$ as the second-conductivity-type (p-type) cladding layer 26 to 0.01 $\mu$m at a growth temperature of 970 °C, and subsequently, was formed Mg doped (Mg concentration: 5 $\times$ $10^{19}$ cm$^{-3}$) $Al_{0.03}Ga_{0.97}N$ to 20 nm.

Next, the wafer was gradually cooled in the MOCVD growth furnace and then was removed to terminate film crystal growth.

At this step, a PL intensity was measured for determining quality of the thin-film crystal layer obtained. Here, an excitation wavelength of the light used was 325 nm and an excitation density was 0.7 mW/cm$^2$.

Then, by plasma CVD, on the thin-film crystal layer was deposited an $SiN_x$ film to a film thickness of 0.125 $\mu$m under the deposition conditions of substrate heating temperature: 350 °C, $SiH_4$ flow rate: 7 sccm, $NH_3$ flow rate: 13 sccm, $N_2$ flow rate: 225 sccm, pressure: 100 Pa and RF power: 200 W.

PL measurement after deposition indicated that an average integral PL intensity in the wafer plane was 1.59 times as much as that after the step of film crystal growth, indicating that an integral PL intensity was also improved in the wafer having a different film crystal structure.

Next, a resist pattern was formed on the $SiN_x$ film by photolithography. Then, an exposed part in the $SiN_x$ film was removed with buffered hydrofluoric acid. Then, the resist pattern was completely removed with acetone.

At this step, a PL intensity was measured at one point in the removed part in the $SiN_x$ film, and as a result, it was 1.41 times as much as that in a PL intensity at the substantially same point in the step of film crystal growth, indicating the effect of improving a PL intensity, but the intensity was slightly reduced in comparison with the PL intensity in the step of mask deposition, indicating a reduced degree of the improvement effect.

Then, the remaining $SiN_x$ film was completely removed with buffered hydrofluoric acid, and again, an $SiN_x$ film was deposited to a film thickness of 50 nm by plasma CVD over the whole surface of the wafer. The conditions of $SiN_x$ film deposition were substrate heating temperature: 250 °C, $SiH_4$ flow rate: 9 sccm, $NH_3$ flow rate: 13 sccm, $N_2$ flow rate: 225 sccm, pressure: 200 Pa and RF power: 250 W.

Here, a PL intensity was measured at the substantially same point as PL intensity measurement after removal of the predetermined part in the $SiN_x$ film in the previous step, and it was 1.55 times as much as that in a PL intensity at the substantially same point after the film crystal growth. This step again demonstrated the effect of $SiN_x$ deposition in crystal quality improvement.

Example 11

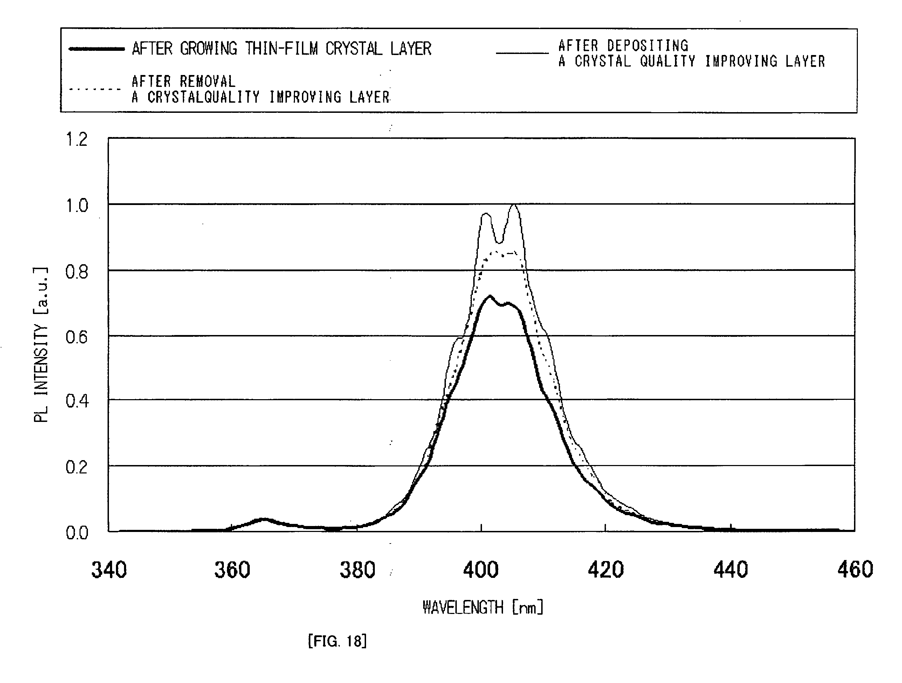

A film crystal grown wafer was prepared as described in Example 1, and at this step, a PL intensity was determined for evaluating quality of the thin-film crystal layer obtained. Here, an excitation wavelength of the light used was 325 nm and an excitation density was 0.7 mW/cm$^2$. FIG. 18 shows a PL intensity at a typical position at this step (the step of film crystal growth) as a bold solid line. Here, an integral PL intensity was measured including an interference peak in an interface between a sapphire substrate and the thin-film crystal layer.

Then, on the thin-film crystal layer was deposited an $SiO_xN_y$ film to a thickness of 0.19 $\mu$m by plasma CVD. This corresponds to deposition of $SiO_xN_y$ to be an etching mask for the first etching step in Example 1 over the whole surface of the wafer. The conditions of $SiO_xN_y$

film deposition were a pressure of 150 Pa and an RF power of 250 W under substrate heating temperature: 250 °C, $SiH_4$ flow rate: 7 sccm, $NH_3$ flow rate: 13 sccm, $N_2O$ flow rate: 10 sccm and $N_2$ flow rate: 100 sccm.

PL measurement after depositing the $SiO_xN_y$ film indicated that an average integral PL intensity in the wafer plane was increased to 1.30 times as much as the step of film crystal growth. A PL intensity in a typical position at this step (the step of mask deposition) is indicated by a narrow solid line in FIG. 18. Thus, by depositing an $SiO_xN_y$ film to be an etching mask for the first etching step, it is demonstrated that the thin-film crystal layer is effective in improving crystal quality.

Furthermore, as determined by a spectroscopic ellipsometer, a refractive index of the $SiO_xN_y$ film was 1.71 at a wavelength of 405 nm and 1.68 at a wavelength of 633 nm.

Next, a resist pattern was formed on the $SiO_xN_y$ film by photolithography. Then, an exposed part in the $SiO_xN_y$ film was removed with a mixture of hydrofluoric acid and ammonium fluoride (1:5 by volume). The etching was conducted at room temperature for 10 min.

Then, the resist pattern was completely removed with acetone. This corresponds to preparation of an $SiO_xN_y$ etching mask by patterning an $SiO_xN_y$ mask in Example 1.

At this step (the step of mask removal), a PL intensity was measured at one point in the removed part in the $SiO_xN_y$ film, and as a result, it was 1.16 times as much as that in a PL intensity at the substantially same point in the step of film crystal growth, and the intensity was reduced in comparison with the PL intensity in the step of mask deposition, indicating a reduced degree of the improvement effect. However, at this step, the effect as a crystal quality improving layer was maintained. A PL intensity at a typical position at this point is indicated by a broken line in FIG. 18.

Example 12

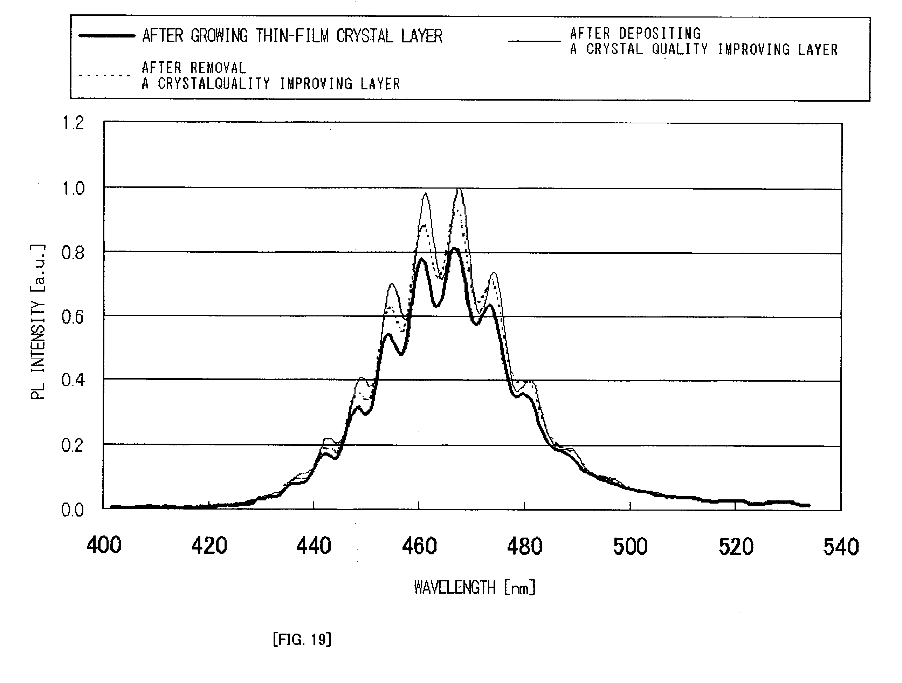

A film crystal grown wafer was prepared as described in Example 11, except that an emission wavelength (center wavelength) peak was changed to 465 nm, and at this step, a PL intensity was determined for evaluating quality of the thin-film crystal layer obtained. FIG. 19 shows a PL intensity at a typical position at this step (the step of film crystal growth) as a bold solid line. Here, an integral PL intensity was measured including an interference peak in an interface between a sapphire substrate and the thin-film crystal layer.

Then, on the thin-film crystal layer was deposited an $SiO_xN_y$ film to a thickness of 0.19 $\mu$m by plasma CVD. The conditions of $SiO_xN_y$ film deposition were a pressure of 150 Pa and an RF power of 250 W under substrate heating temperature: 250 °C, $SiH_4$ flow rate: 7 sccm, $NH_3$ flow rate: 13 sccm, $N_2O$ flow rate: 20 sccm and $N_2$ flow rate: 100 sccm.

PL measurement after depositing the $SiO_xN_y$ film indicated that an average integral PL intensity in the wafer plane was increased to 1.16 times as much as the step of film crystal growth. A PL intensity in a typical position at this step (the step of mask deposition) is indicated by a narrow solid line in FIG. 19. Thus, by depositing an $SiO_xN_y$ film to be an etching mask for the first etching step, it is demonstrated that the thin-film crystal layer is effective in improving crystal quality.

Furthermore, as determined by a spectroscopic ellipsometer, a refractive index of the $SiO_xN_y$ film was 1.59 at a wavelength of 405 nm and 1.56 at a wavelength of 633 nm.

Next, as described in Example 11, a resist pattern was formed on the $SiO_xN_y$ film by photolithography. Then, an exposed part in the $SiO_xN_y$ film was removed with a mixture of hydrofluoric acid and ammonium fluoride. Then, the resist pattern was completely removed with acetone.

At this step (the step of mask removal), a PL intensity was measured at one point in the removed part in the $SiO_xN_y$ film, and as a result, it was 1.12 times as much as that in a PL intensity at the substantially same point in the step of film crystal growth, and the intensity was reduced in comparison with the PL intensity in the step of mask deposition, indicating a reduced degree of the improvement effect. However, at this step, the effect as a crystal quality improving layer was maintained. A PL intensity at a typical position at this step is indicated by a broken line in FIG. 19.

Example 13

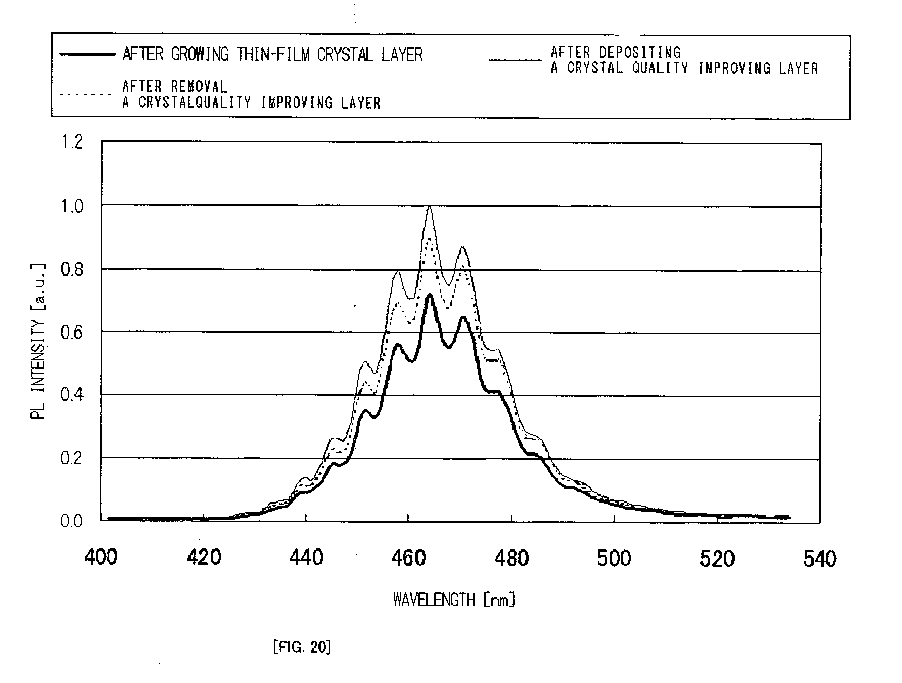

A film crystal grown wafer was prepared as described in Example 12, and at this step, a PL intensity was determined for evaluating quality of the thin-film crystal layer obtained. FIG. 20 shows a PL intensity at a typical position at this step (the step of film crystal growth) as a bold solid line. Here, an integral PL intensity was measured including an interference peak in an interface between a sapphire substrate and the thin-film crystal layer.

Then, on the thin-film crystal layer was deposited an $SiO_xN_y$ film to a thickness of 0.16 $\mu$m by plasma CVD. The conditions of $SiO_xN_y$ film deposition were a pressure of 150 Pa and an RF power of 250 W under substrate heating temperature: 250 °C, $SiH_4$ flow rate: 7 sccm, $NH_3$ flow rate: 13 sccm, $N_2O$ flow rate: 40 sccm and $N_2$ flow rate: 100 sccm.

PL measurement after depositing the $SiO_xN_y$ film indicated that an average integral PL intensity in the wafer plane was increased to 1.29 times as much as the step of film crystal growth. A PL intensity in a typical position at this step (the step of mask deposition) is indicated by a narrow solid line in FIG. 20. Thus, it is demonstrated that the thin-film crystal layer is effective in improving crystal quality by depositing an $SiO_xN_y$ film to be an etching mask for the first etching step.

Furthermore, as determined by a spectroscopic ellipsometer, a refractive index of the $SiO_xN_y$ film was

1.47 at a wavelength of 405 nm and 1.46 at a wavelength of 633 nm.

Next, as described in Example 11, a resist pattern was formed on the $SiO_xN_y$ film by photolithography. Then, an exposed part in the $SiO_xN_y$ film was removed with a mixture of hydrofluoric acid and ammonium fluoride. Then, the resist pattern was completely removed with acetone.

At this step (the step of mask removal), a PL intensity was measured at one point in the removed part in the $SiO_xN_y$ film, and as a result, it was 1.21 times as much as that in a PL intensity at the substantially same point in the step of film crystal growth, and the intensity was reduced in comparison with the PL intensity in the step of mask deposition, indicating a reduced degree of the improvement effect. However, at this step, the effect as a crystal quality improving layer was maintained. A PL intensity at a typical position at this point is indicated by a broken line in FIG. 20.

Comparative Example 1

In Comparative Example 1, an insulating film was made reflective. Specifically, an insulating film was formed as a multilayer film consisting of a first layer made of $SiO_x$ with a film thickness of 67.6 nm by electron beam deposition and a second layer made of $TiO_2$ with a film thickness of 42.6 nm by electron beam deposition for adjusting a reflectance of a light vertically entering the insulating film from the thin-film crystal layer side to 52 %. There was not formed $SiN_x$ as the uppermost layer in the insulating film. The conditions of $TiO_2$ deposition were substrate heating temperature: 250 °C and acceleration voltage: 6 kV, and $O_2$ was introduced such that a vacuum at the initiation of deposition was $1.5 \times 10^{-2}$ Pa. The conditions of subsequent $SiO_x$ deposition were substrate heating temperature: 250 °C and acceleration voltage: 6 kV, and $O_2$ was introduced such that a vacuum at the initiation of deposition was $2.0 \times 10^{-2}$ Pa. A light-emitting element was prepared using the other components and production steps as described in Example 1.

The light-emitting element thus produced exhibited the following initial properties; a total radiation flux at 350 mA current injection: 183 mW and an emission wavelength (center wavelength) peak: 403 nm.

Using the light-emitting element thus produced, a luminescence source emitting white light was prepared as described in Example 1. For the luminescence source obtained, a high-temperature high-humidity life test was conducted under the conditions as described in Example 1. Consequently, a luminous flux of white light after 1000 hours was reduced only by as large as 30 % compared to a luminous flux immediately after the test was started, demonstrating rapid reduction in a luminous flux.

Comparative Example 2

A light-emitting element was prepared as described in Example 1, except that an insulating film was formed as a monolayer film made of $SiO_x$ with a film thickness of 135 nm by plasma CVD for adjusting a reflectance of a light vertically entering the insulating film from the thin-film crystal layer side to 18 %, and there was not formed $SiN_x$ as the uppermost layer of the insulating film. The conditions of $SiO_x$ deposition were a pressure of 200 Pa and an RF power of 300 W under substrate heating temperature: 400 °C, $SiH_4$ flow rate: 9 sccm and $N_2O$ flow rate: 180 sccm.

The light-emitting element thus produced exhibited the following initial properties; a total radiation flux at 350 mA current injection: 182 mW and an emission wavelength (center wavelength) peak: 400 nm.

Using the light-emitting element thus produced, a luminescence source emitting white light was prepared as described in Example 1. For the luminescence source obtained, a high-temperature high-humidity life test was conducted under the conditions as described in Example 1. Consequently, a luminous flux of white light after 1000 hours was reduced only by as large as 26 % compared to a luminous flux immediately after the test was started, demonstrating rapid reduction in a luminous flux.

Comparative Example 3

A light-emitting element was prepared as described in Example 1, except an insulating film was formed as described below.

First, a first layer made of $SiN_x$ was formed to a film thickness of 10 nm by reactive sputtering. The deposition conditions were substrate heating temperature of 200 °C, Ar flow rate of 10 sccm, $N_2$ flow rate of 5 sccm, a pressure of 0.32 Pa and an RF power of 300 W. After forming the first layer, on the layer was formed a second layer made of $SiO_x$ to a film thickness of 65 nm by plasma CVD for adjusting a reflectance of a light vertically entering the insulating film from the thin-film crystal layer side to 0.7 %. The conditions of $SiO_x$ deposition were a pressure of 200 Pa and an RF power of 300 W under substrate heating temperature: 400 °C, $SiH_4$ flow rate: 9 sccm and $N_2O$ flow rate: 180 sccm. There was not formed $SiN_x$ as the uppermost layer in the insulating film.

The light-emitting element thus produced exhibited the following initial properties; a total radiation flux at 350 mA current injection: 182 mW and an emission wavelength (center wavelength) peak: 400 nm.

Using the light-emitting element thus produced, a luminescence source emitting white light was prepared as described in Example 1. For the luminescence source obtained, a high-temperature high-humidity life test was conducted under the conditions as described in Example 1. Consequently, a luminous flux of white light after 1000 hours was reduced only by as large as 21 % compared to a luminous flux immediately after the test was started, demonstrating rapid reduction in a luminous flux.

Comparative Example 4

In Comparative Example 4, the process until complete removal of an SiNx film formed on the thin-film crystal layer as an etching mask with buffered hydrofluoric acid was conducted as described in Example 8. Again, in Comparative Example 4, a PL intensity was measured after the film crystal growth as described in Example 8.

After removing the SiNx film, an $SiO_x$ film was deposited to a film thickness of 135 nm over the thin-film crystal layer of the whole surface of the wafer by plasma CVD. The conditions of $SiO_x$ film deposition were a pressure of 200 Pa and an RF power of 300 W under substrate heating temperature: 400 °C, $SiH_4$ flow rate: 9 sccm and $N_2O$ flow rate: 180 sccm. This corresponds to deposition of an insulating film over the whole surface of the wafer in Comparative Example 2.

Here, a PL intensity was measured at the substantially same point as PL intensity measurement after removal of the predetermined part with $SF_6$ plasma by RIE in the previous step, and it was 1.29 times as much as a PL intensity at the substantially same point after film crystal growth, indicating less effect of improving crystal quality in comparison with Example 8.

Comparative Example 5

The process until complete removal of an SiNx film formed on the thin-film crystal layer as an etching mask with buffered hydrofluoric acid was conducted as described in Example 8. Again, in Comparative Example 5, a PL intensity was measured after the film crystal growth as described in Example 8.

After removal of the SiNx film, an SiNx film was deposited to a film thickness of 10 nm over the thin-film crystal layer of the whole surface of the wafer by reactive sputtering under the deposition conditions; substrate heating temperature: 200 °C, Ar flow rate: 10 sccm, $N_2$ flow rate: 5 sccm, pressure: 0.32 Pa and RF power: 300 W. This corresponds to deposition of the first layer of the insulating film over the whole surface of the wafer in Comparative Example 3.

Here, a PL intensity was measured at the substantially same point as PL intensity measurement after removal of the predetermined part with $SF_6$ plasma by RIE in the previous step, and it was 1.11 times as much as a PL intensity at the substantially same point after film crystal growth, indicating less effect of improving crystal quality in comparison with Example 8.

Comparative Example 6

A film crystal grown wafer was prepared as described in Example 1, except an emission wavelength (center wavelength) peak was changed to 465 nm, and at this step, a PL intensity was determined for evaluating quality of the thin-film crystal layer obtained. Here, an excitation wavelength of the light used was 325 nm and an excitation density was 0.7 $mW/cm^2$.

Next, on the thin-film crystal layer was deposited an $SiN_x$ film to a film thickness of 0.33 $\mu$m by reactive sputtering under the conditions: substrate heating temperature: 200 °C, Ar flow rate: 10 sccm, $N_2$ flow rate: 5 sccm, pressure: 0.32 Pa and RF power: 300 W.

PL measurement after the deposition indicated that an average integral PL intensity in the wafer plane was reduced to 0.82 times as much as that after film crystal growth. At this step, as described in Example 8, a hydrogen atom concentration and a refractive index of the $SiN_x$ film were measured. As a result, a hydrogen-atom concentration was $3.6 \times 10^{20}$ $atoms/cm^3$, which was lower by one order in comparison with a hydrogen-atom concentration of the $SiN_x$ deposited by plasma CVD as measured in Example 8. Refractive indices were 2.07 at a wavelength of 405 nm and 2.02 at a wavelength of 633 nm, which were significantly different from those in the $SiN_x$ film deposited by plasma CVD.

Next, a resist pattern was formed on the $SiN_x$ film by photolithography. Then, the exposed part in the $SiN_x$ film was removed with buffered hydrofluoric acid. Then, the resist pattern was completely removed with acetone.

Here, at one point in the removed part in the $SiN_x$ film, a PL intensity was measured and was lower, that is 0.72 times, than a PL intensity at the substantially same position after film crystal growth.

Subsequently, the remaining $SiN_x$ film was completely removed with buffered hydrofluoric acid, and over the whole surface of the wafer was deposited an $SiO_x$ film to a film thickness of 50 nm by plasma CVD. The deposition conditions were a pressure of 200 Pa and an RF power of 300 W under substrate heating temperature: 400 °C, $SiH_4$ flow rate: 9 sccm and $N_2O$ flow rate: 180 sccm.

Here, a PL intensity was measured at the substantially same point as PL intensity measurement after removal of the predetermined part with buffered hydrofluoric acid in the previous step, and it was 0.65 times as much as a PL intensity at the substantially same point after film crystal growth, indicating significant reduction.

**Claims**

1. A semiconductor light-emitting element comprising a thin-film crystal layer in which a buffer layer, a first-conductivity-type semiconductor layer including a first-conductivity-type cladding layer, an active layer structure and a second-conductivity-type semiconductor layer including a second-conductivity-type cladding layer are laminated in sequence, wherein said thin-film crystal layer is covered with an insulating film at least a part of said second-conductivity-type semiconductor layer, and
said insulating film comprises a crystal quality improving layer for improving crystallinity of said thin-film crystal layer.

2. The semiconductor light-emitting element according to claim 1, wherein said insulating film further comprises at least one antireflection layer which is formed covering at least a part of said crystal quality improving layer and reduces reflection of a light entering from the side of said thin-film crystal layer.

3. The semiconductor light-emitting element according to claim 2, wherein when a light reflectance of said insulating film when a light generated in said thin-film crystal layer vertically enters said insulating film is R %, said antireflection layer is adjusted such that the relation:

$$0.001\ (\%) < R < 3\ (\%)$$

is satisfied.

4. The semiconductor light-emitting element according to claim 3, wherein said antireflection layer consists of a single layer.

5. The semiconductor light-emitting element according to any one of claims 2 to 4, wherein said antireflection layer is made of a material selected from the group consisting of $AlO_x$, $SiO_x$, $TiO_x$, $MgF_2$, $SiN_x$ and $SiO_xN_y$.

6. The semiconductor light-emitting element according to any one of claims 1 to 5, wherein the whole surface of said second-conductivity-type-side electrode facing said second-conductivity-type semiconductor layer is in contact with said second-conductivity-type semiconductor layer and said insulating film also covers a part of said second-conductivity-type-side electrode.

7. The semiconductor light-emitting element according to any one of claims 1 to 6, wherein said first-conductivity-type-side electrode is in contact with said first-conductivity-type semiconductor layer only in a part of the surface facing said first-conductivity-type semiconductor layer, and a part of said insulating film intervenes between said first-conductivity-type semiconductor layer and said first-conductivity-type-side electrode.

8. The semiconductor light-emitting element according to any one of claims 1 to 7, wherein said insulating film is in contact with at least a part of the sidewall of said thin-film crystal layer.

9. The semiconductor light-emitting element according to any one of claims 1 to 8, wherein said first-conductivity-type semiconductor layer, said active layer structure and said second-conductivity-type semiconductor layer are nitride semiconductors.

10. The semiconductor light-emitting element according to claim 9, wherein each of said nitride semiconductors comprises at least one element selected from the group consisting of In, Ga, Al and B.

11. The semiconductor light-emitting element according to any one of claims 1 to 10, wherein a center wavelength $\lambda$ (nm) of a light emitted from the inside of said active layer structure satisfies the following formula.

$$300\ (\mathrm{nm}) \leq \lambda \leq 430\ (\mathrm{nm})$$

12. The semiconductor light-emitting element according to any one of claims 1 to 11, wherein the first-conductivity-type is n-type and the second-conductivity-type is p-type.

13. The semiconductor light-emitting element according to any one of claims 1 to 12, wherein the surface of said second-conductivity-type semiconductor layer contains Mg and H.

14. The semiconductor light-emitting element according to any one of claims 1 to 13, wherein said crystal quality improving layer contains N and H.

15. The semiconductor light-emitting element according to claim 14, wherein a hydrogen-atom concentration in said crystal quality improving layer is $1 \times 10^{21}$ atoms/cm$^3$ or more and $1 \times 10^{22}$ atoms/cm$^3$ or less.

16. The semiconductor light-emitting element according to any one of claims 1 to 15, wherein said crystal quality improving layer contains one or more of a nitride and an oxynitride.

17. The semiconductor light-emitting element according to claim 16, wherein said nitride and said oxynitride contain one or more elements selected from the group consisting of B, Al, Si, Ti, V, Cr, Mo, Hf, Ta and W.

18. The semiconductor light-emitting element according to any one of claims 1 to 17, wherein the semiconductor light-emitting element is a flip-chip type in which both first-conductivity-type-side electrode and second-conductivity-type-side electrode for injecting current into said first-conductivity-type semiconductor layer and said second-conductivity-type semiconductor layer, respectively, are disposed in the same side as said first-conductivity-type semiconductor layer to said buffer layer.

**19.** A process for manufacturing a semiconductor light-emitting element, sequentially comprising:

a step of crystal growing where on a substrate is formed a thin-film crystal layer comprising a buffer layer, a first-conductivity-type semiconductor layer including a first-conductivity-type cladding layer, an active layer structure and a second-conductivity-type semiconductor layer including a second-conductivity-type cladding layer;

a step of forming a second-conductivity-type-side electrode where a second-conductivity-type-side electrode is formed on a predetermined second current injection area on said second-conductivity-type semiconductor layer;

a first etching step where a part of said first-conductivity-type-side semiconductor layer is exposed;

a step of forming an insulating film where the insulating film comprising a crystal quality improving layer for improving crystallinity of said thin-film crystal layer is formed such that the insulating film covers at least a part of said second-conductivity-type semiconductor layer and a part of said first-conductivity-type semiconductor layer;

a step of forming a first current injection area where the first current injection area is formed by removing at least a part on said first-conductivity-type semiconductor layer of said insulating film; and

a step of forming a first-conductivity-type-side electrode where the first-conductivity-type-side electrode is formed on said first current injection area.

**20.** The process for manufacturing a semiconductor light-emitting element according to claim 19, wherein said step of forming the insulating film comprises forming an antireflection layer reducing reflection of a light entering on said crystal quality improving layer from said thin-film crystal layer side.

**21.** The process for manufacturing a semiconductor light-emitting element according to claim 20, wherein when a reflectance when a light from the side of said thin-film crystal layer vertically enters said crystal quality improving layer and said antireflection layer is R %, said step of forming the insulating film comprises forming said antireflection layer such that the relation

$$0.001\,(\%) < R < 3\,(\%)$$

is satisfied.

**22.** The process for manufacturing a semiconductor light-emitting element according to claim 20 or 21, wherein said step of forming the insulating film comprises continuously forming said crystal quality improving layer and said antireflection layer in the same deposition apparatus.

**23.** The process for manufacturing a semiconductor light-emitting element according to any one of claims 19 to 22, wherein said crystal quality improving layer comprises one or more of a nitride and an oxynitride.

**24.** The process for manufacturing a semiconductor light-emitting element according to claim 23, wherein said nitride and said oxynitride contain one or more elements selected from the group consisting of B, Al, Si, Ti, V, Cr, Mo, Hf, Ta and W.

**25.** The process for manufacturing a semiconductor light-emitting element according to any one of claims 19 to 24, wherein said step of forming the insulating film comprises forming said crystal quality improving layer using a gas species containing at least ammonia as a nitrogen source.

**26.** The process for manufacturing a semiconductor light-emitting element according to any one of claims 19 to 25, wherein said step of forming the insulating film comprises forming said crystal quality improving layer using a gas species containing at least $N_2O$ as an oxygen source.

**27.** The process for manufacturing a semiconductor light-emitting element according to any one of claims 19 to 26, wherein said step of forming the insulating film comprises forming said crystal quality improving layer by plasma CVD.

**28.** The process for manufacturing a semiconductor light-emitting element according to any one of claims 19 to 27, wherein said step of forming the insulating film comprises forming said crystal quality improving layer such that a hydrogen-atom concentration is $1 \times 10^{21}$ atoms/cm$^3$ or more and $1 \times 10^{22}$ atoms/cm$^3$ or less.

[FIG. 1]

[FIG. 1-1]

EP 2 221 884 A1

[FIG. 1-2]

38

[FIG. 1-3]

[FIG. 2]

[FIG. 3]

[FIG. 4]

[FIG. 5]

[FIG. 6]

[FIG.7]

[FIG. 8]

[FIG. 9]

[FIG. 10]

[FIG. 11]

THICKNESS OF SiO$_x$ (nm)

[FIG. 12]

THICKNESS OF SiO$_x$ (nm)

[FIG. 13]

[FIG. 14]

THICKNESS OF MgF₂ (nm)

[FIG. 15]

[FIG. 16]

THICKNESS OF $SiO_x$ (nm)

[FIG. 17]

[FIG. 18]

EP 2 221 884 A1

AFTER GROWING THIN-FILM CRYSTAL LAYER

AFTER DEPOSITING
A CRYSTAL QUALITY IMPROVING LAYER

AFTER REMOVAL
A CRYSTALQUALITY IMPROVING LAYER

PL INTENSITY [a.u.]

WAVELENGTH [nm]

[FIG. 19]

[FIG. 20]

EP 2 221 884 A1

[FIG. 21]

[FIG. 22]

**INTERNATIONAL SEARCH REPORT**

| | International application No. |
|---|---|
| | PCT/JP2008/069682 |

A. CLASSIFICATION OF SUBJECT MATTER
*H01L33/00*(2006.01)i

According to International Patent Classification (IPC) or to both national classification and IPC

B. FIELDS SEARCHED

Minimum documentation searched (classification system followed by classification symbols)
H01L33/00, H01S5/00-5/50

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2000-332357 A  (Matsushita Electric Industrial Co., Ltd.),<br>30 November, 2000 (30.11.00),<br>Par. Nos. [0011] to [0026]; Figs. 1 to 6<br>(Family: none) | 1,8-12,16-18<br>2-7,13-15,<br>19-28 |
| Y | WO 2006/043796 A1  (SEOUL OPTO-DEVICE CO., LTD.),<br>27 April, 2006 (27.04.06),<br>Fig. 7<br>& US 2008/0006836 A1    & EP 1810351 A<br>& KR 10-2006-0035424 A  & KR 10-2006-0059783 A<br>& CN 101084583 A | 2-7,13-15,<br>19-28 |

☒ Further documents are listed in the continuation of Box C.      ☐ See patent family annex.

| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
|---|---|

| Date of the actual completion of the international search<br>13 November, 2008 (13.11.08) | Date of mailing of the international search report<br>25 November, 2008 (25.11.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/069682

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2007-214276 A  (Mitsubishi Chemical Corp.), 23 August, 2007 (23.08.07), Par. Nos. [0086] to [0114]; Fig. 6A & WO 2007/091432 A1 | 6,7,19-28 |
| Y | JP 2006-229172 A  (Toshiba Corp.), 31 August, 2006 (31.08.06), Par. No. [0014]; Fig. 1 & US 2006/0187988 A1 | 13 |
| Y | JP 2005-286135 A  (Yudina Debaisu Kabushiki Kaisha), 13 October, 2005 (13.10.05), Par. Nos. [0055] to [0057]; Fig. 8 & US 2005/0221628 A1 | 14,15,28 |
| Y | JP 2005-244245 A  (Osram Opto Semiconductors GmbH.), 08 September, 2005 (08.09.05), Par. Nos. [0038] to [0039]; Fig. 2 & US 2005/0233484 A1    & EP 1569281 A2 & DE 102004029412 A | 26 |
| P,X | JP 2008-130595 A  (Sharp Corp.), 05 June, 2008 (05.06.08), Full text; all drawings (Family: none) | 1,8-10,12, 16,17 |

Form PCT/ISA/210 (continuation of second sheet) (April 2007)

**EP 2 221 884 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3423328 B
- JP 2000164938 A
- JP 2002344015 A